(19) Europäisches Patentamt
European Patent Office
Office européen des brevets

(11) **EP 4 354 512 A2**

(12) **EUROPÄISCHE PATENTANMELDUNG**

(43) Veröffentlichungstag:
**17.04.2024  Patentblatt 2024/16**

(21) Anmeldenummer: 23210271.5

(22) Anmeldetag: **23.11.2015**

(51) Internationale Patentklassifikation (IPC):
**H01L 29/66** *(2006.01)*    **H01L 29/94** *(2006.01)*

(52) Gemeinsame Patentklassifikation (CPC):
**H01L 29/66181; H01L 29/945;** H01L 27/0694

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.11.2014  DE 102014223904**

(62) Dokumentnummer(n) der früheren Anmeldung(en) nach Art. 76 EPÜ:
**15195837.8 / 3 024 033**

(71) Anmelder:
• **Fraunhofer-Gesellschaft zur Förderung der angewandten Forschung e.V.**
**80686 München (DE)**
• **Friedrich-Alexander-Universität Erlangen-Nürnberg**
**91054 Erlangen (DE)**

(72) Erfinder:
• **Krach, Florian**
**90409 Nürnberg (DE)**
• **Erlbacher, Tobias**
**91058 Erlangen (DE)**

(74) Vertreter: **Schairer, Oliver Michael et al Schoppe, Zimmermann, Stöckeler Zinkler, Schenk & Partner mbB Patentanwälte Radlkoferstraße 2 81373 München (DE)**

Bemerkungen:
•Diese Anmeldung ist am 16-11-2023 als Teilanmeldung zu der unter INID-Code 62 erwähnten Anmeldung eingereicht worden.
•Die Patentansprüche wurden nach dem Eingangstag eingereicht (R. 68(4) EPÜ).

(54) **KONDENSATOR UND VERFAHREN ZUM HERSTELLEN DESSELBEN**

(57)    In einem Verfahren zum Herstellen eines Kondensators wird eine Dielektrikumsstruktur in einem Graben eines Halbleitersubstrats erzeugt. Die Dielektrikumsstruktur weist eine Mehrzahl von aneinandergrenzenden Dielektrikumsschichten auf, die einander entgegengesetzte Materialspannungen aufweisen.

EP 4 354 512 A2

**Beschreibung**

Die vorliegende Erfindung bezieht sich auf einen Kondensator mit einem Halbleitersubstrat und auf ein Verfahren zum Herstellen desselben. Die vorliegende Erfindung bezieht sich ferner auf eine Stresskompensation in monolithischen Grabenkondensatoren für leistungselektronische Anwendungen zur Erhöhung der Integrationsdichte.

Monolithische integrierte Kondensatoren und RC-Glieder (R = Widerstand, C = Kapazität) mit Betriebsspannungen von 200 Volt oder mehr, wie sie etwa aus der US 7,738,226 B2 bekannt sind, finden in leistungselektronischen Schaltungen Verwendung. Sie stellen hierbei eine Alternative zu Folien- und Keramikkondensatoren dar und besitzen gegenüber diesen Vorteile. Monolithisch integrierte Kondensatoren werden mit Hilfe derselben Aufbau- und Verbindungstechnik in Schaltungen aufgebaut, wie sie für aktive Leistungsschalter (z.B. doppelt diffundierte Metalloxidhalbleiter - Double-Diffused Metal-Oxide Semiconductor, DMOS - Transistoren und Bipolartransistoren mit isolierter Gate-Elektrode, Insulated Gate Bipolar Transistor - IGBT) und Dioden verwendet wird. Hierdurch vereinfacht sich die Aufbau- und Verbindungstechnik von Leistungsmodulen. Dabei profitieren sie auch von einer niederinduktiveren Anbindung und einer besseren Wärmeabfuhr im Vergleich zu Keramik- oder Folienkondensatoren. Durch den niederinduktiven Aufbau erlauben die monolithisch integrierten Kondensatoren eine effizientere Dämpfung von Schwingungen. Außerdem unterliegt ihre elektrische Kapazität nur geringen Schwankungen mit der Betriebstemperatur und sie weisen eine gut vorhersagbare Lebensdauer auf. Gegenüber Keramikkondensatoren mit hoher Integrationsdichte (sogenannte Klasse 2 Keramiken) zeichnen sich diese Bauelemente auch durch eine hohe Temperatur-, Spannungs- und Frequenzstabilität aus.

Vom Dorp et al., "Dielectric Layers suitable for High Voltage Integrated Trench Capacitors", Journal of Vacuum Science and Technology B 29, 01AB04 (2011) zeigt solche Kondensatoren, wie sie für Betriebsspannungen bis 200 Volt geeignet sind. Hierbei kommt ein Dielektrikum aus 400 nm Siliziumdioxid bzw. ein Dielektrikum aus 20 nm Siliziumdioxid und 500 nm Siliziumnitrid zum Einsatz. Der Herstellungsprozess ist dort auch offenbart.

Die monolithisch integrierten Kondensatoren und RC-Glieder werden durch Metall-Isolator-Halbleiter (Metal-Insulator-Semiconductor-MIS) Kondensatoren realisiert. Für die genannten Spannungsbereiche ist dazu die Verwendung hinreichend dicker dielektrischer Schichten mit entsprechender Durchbruchstabilität notwendig. Die Dielektrika Siliziumnitrid und Siliziumoxid haben sich hierfür aufgrund ihrer hohen Durchbruchfeldstärken von über 5 MV/cm bzw. über 10 MV/cm, ihrer prozesstechnischen Verfügbarkeit und einer hohen erzielbaren Ausbeute, d.h. einer geringen Defektdichte, als geeignete Materialien erwiesen, so dass diese basierend auf der erzielbaren Spannungsfestigkeit der hergestellten Kondensatoren oft als dielektrische Materialien gewählt werden. Insbesondere dicke Siliziumnitridschichten zeichnen sich durch niedrige Leckströme und hohe Durchbruchspannungen aus.

Wie in der Halbleitertechnologie üblich, nehmen die Kosten pro Bauelemente näherungsweise linear mit zunehmender Chipfläche zu. Deshalb bedarf es für die kommerzielle Verwertung aufgrund der Konkurrenz zu Folien- und Keramikkondensatoren einer hohen Integrationsdichte. Gegenwärtig wird dies dadurch realisiert, dass die Kondensatoren mit einer begrenzten Oberflächenvergrößerung gefertigt werden. Diese Oberflächenvergrößerung V kann wie folgt bestimmt werden:

$$V = \frac{A^*}{A_0} = \frac{C_{3D}}{\varepsilon_0 \varepsilon_{SiO_2}} d_{CET} = \frac{C_{3D}}{C_0}$$

Dabei bezeichnet $A^*$ die effektive Fläche des Kondensators, der durch die Oberflächenvergrößerung V entsteht. $A_0$ bezeichnet die planare Fläche der Bauelemente, das heißt der Chipgröße. Cso bezeichnet die flächenbezogene Kapazität des 3D-integrierten Kondensators. $C_0$ bezeichnet die flächenbezogene Kapazität eines planaren Plattenkondensators der Fläche $A_0$ mit gleichen dielektrischen Schichten, aber ohne Oberflächenvergrößerung. $d_{CET}$ bezeichnet die effektive, elektrisch relevante, Schichtdicke des Dielektrikums bezogen auf eine äquivalente Siliziumdioxidschicht mit einer spezifischen Dielektrizitätskonstante $\varepsilon_r$ von 3,9.

Um eine möglichst hohe Oberflächenvergrößerung zu erreichen, werden die Kondensatoren auf einer Halbleiterscheibe hergestellt, deren Oberfläche (meist ganzflächig) durch dreidimensionale Strukturierung vergrößert wurde. Diese Strukturierung kann beispielsweise in der Form von tiefen Löchern realisiert sein. Die Oberflächenvergrößerung wird hierbei insbesondere von Durchmesser, Abstand und Tiefe der erzeugten Löcher beeinflusst.

Dicke dielektrische Schichten, wie sie für die gewünschte Spannungsfestigkeit benötigt werden, müssen daher mit einer großen effektiven Oberfläche der Kondensatoren kombiniert werden. Bei der Herstellung solcher MIS-Kondensatoren führt dies zu einer starken Verbiegung der Halbleiterscheibe, welche aus den mechanischen Spannungen (mechanischer Stress) in den Schichten und dem darunter liegenden Substrat resultiert. Mit steigender Oberflächenvergrößerung nimmt die Scheibenverbiegung so stark zu, dass eine Weiterprozessierung (besonders nach dem Entfernen der Schichten von der Rückseite der Halbleiterscheibe) aufgrund der mechanischen Verbiegung nicht mehr möglich ist. Eine Verbiegung der Halbleiterscheibe in dieser Größenordnung stellt deshalb eine Barriere für die Einführung monolithisch integrierter Kondensatoren und RC-Glieder mit hoher Integrationsdichte für Betriebsspannungen von 600 Volt und mehr dar.

Grundsätzlich ist die Herstellung von Siliziumkondensatoren bereits aus der Technologie der dynamischen Speicher mit wahlfreiem oder direktem Zugriff (Dynamic Random Access Memory - DRAM) bekannt. Allerdings kommen dort nur sehr dünne Dielektrika (bis etwa 30 nm) und Gräben mit Durchmessern im Sub-Mikrometer-Bereich zum Einsatz, da eine Spannungsfestigkeit von ca. 10 Volt nicht überschritten werden muss. Bei derart dünnen Dielektrika tritt eine Verbiegung der Halbleiterscheibe in lediglich geringem Umfang auf.

Monolithisch integrierte Kondensatoren sind außerdem Bestandteil von SONOS-Speicherzellen (SONOS = Silicon-Oxide-Nitride-Oxide-Silicon, Silizium-Oxid-Nitrid-Oxid-Silizium), die als Flash-Speicher Anwendung finden, einen Dielektrikumsstapel aus Siliziumdioxid, Siliziumnitrid und Siliziumdioxid aufweisen und beispielsweise in EP 1535338 A2 beschrieben sind. Die Spannungsfestigkeit der Dielektrika in solchen Schichten ist jedoch auf unter 30 Volt begrenzt. Auch hierbei kommen dünne Dielektrika bis zu einer Dicke von 30 nm zur Anwendung, bei denen die Verbiegung der Halbleiterscheibe von geringer Relevanz für die Herstellbarkeit sind.

Bislang sind monolithisch integrierte Silizium-Kondensatoren mit Betriebsspannungen bis 30 Volt und Durchbruchspannungen bis max. 100 Volt bekannt. Monolithisch integrierte Kondensatoren mit Betriebsspannungen im Bereich von 200 Volt und mehr sind bisher nicht erhältlich.

Es sind integrierte RC-Glieder mit 200 Volt Nennspannung, einer Kapazität von 15 Nanofarad, einer Chipfläche von 10 mm² bekannt. Für diese 200 Volt-Bauelemente wird als Dielektrikum ein Schichtstapel von 20 nm Siliziumoxid und 500 nm Siliziumnitrid eingesetzt. Die Bauelemente weisen eine reproduzierbare Integrationsdichte von ca. 1,5 nF/mm² und eine Oberflächenvergrößerung von 10 bis 12 auf, ohne dass die Verbiegung der Halbleiterscheibe sich negativ auf den Herstellungsprozess auswirkt.

Probleme mit der Prozessierung von strukturierten Halbleiterscheiben bei der Verwendung dicker dielektrischer Schichten wurden erstmals in Vom Dorp, J., "Monolithisches RC-Element für leistungselektronische Anwendungen" dokumentiert. Hier wird eine mit tiefen Löchern strukturierte Halbleiterscheibe gezeigt, auf der eine 1 μm dicke Siliziumoxidschicht zu einer konkaven Verbiegung von über 1,5 mm führt. Dies wird hier mit weiteren Halbleiterscheiben verglichen, auf denen unterschiedliche dielektrische Schichtstapel mit einer maximalen Gesamtdicke von 750 nm hergestellt wurden. Die genannten Scheiben weisen eine reduzierte Verbiegung von max. 160 μm auf. Die verwendeten Schichtstapel sind für Anwendungen mit Betriebsspannungen bis 600 Volt jedoch nicht ausreichend.

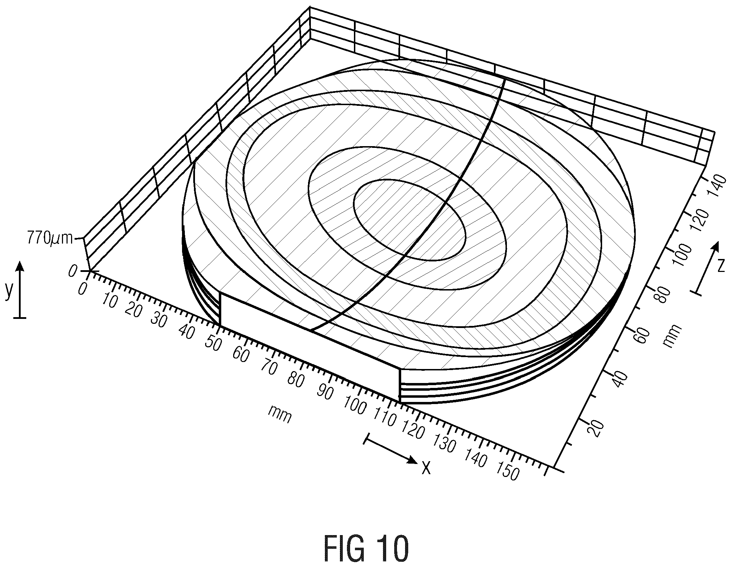

Erste Erfolge bei der Herstellung monolithisch integrierter RC-Glieder für Betriebsspannungen bis 600 Volt konnten durch den Einsatz eines dielektrischen Schichtstapels aus 20 nm Siliziumoxid und 1050 nm Siliziumnitrid realisiert werden (vgl. F. Krach "Silicon Nitride as a Potential Dielectric for 600 Volt Capacitors", WoDiM 2014, Cork, Ireland). Die hergestellten Bauelemente mit einer flächenbezogenen Kapazität von 0,66 nF/mm² weisen eine Durchbruchspannung von etwa 1.050 Volt auf und können bis 600 Volt mit einem Leckstrom von unter 10 nA betrieben werden. Bei einer realisierten Oberflächenvergrößerung von etwa 10 weist die verwendete 150 mm-Halbleiterscheibe jedoch eine konvexe Verbiegung von über 750 μm auf, welche in Fig. 10 dargestellt ist. In diesem Fall verhindert die starke Verbiegung das Aufbringen und Strukturieren einer zusätzlichen Passivierungsschicht aus Polyimid, wie sie für den Betrieb der Bauelemente bei 600 Volt vorteilhaft ist.

Neben der Durchbruchfestigkeit bestimmt die Dicke der dielektrischen Schichten auch die statistische Lebensdauer und Ausfallrate der monolithischen Kondensatoren. Prognosen für Bauelemente mit 200 Volt Nennspannung lassen darauf schließen, dass für einen kommerziellen Einsatz von monolithischen Kondensatoren mit 600 Volt Nennspannung im Industrie- und Automobilbereich die Schichtdicken noch weiter erhöht werden müssen. Hierfür könnte beispielsweise eine Skalierung des Dielektrikums der 200 Volt-Bauelemente ausreichend sein. Dies entspricht einem dielektrischen Schichtstapel aus 60 nm dickem Siliziumoxid und 1500 nm dickem Siliziumnitrid. Die bisherigen Erkenntnisse zeigen jedoch, dass Bauelemente mit einem solchen Schichtstapel bereits mit einer geringen Oberflächenvergrößerung nicht mehr herstellbar sind. Auch eine Herstellung auf einer planaren Oberfläche scheint nicht möglich, da hier die hohen mechanischen Spannungen der Schichten dazu führen, dass diese von der Oberfläche abplatzen oder sich Risse ausbilden, welche sich bis in das Substrat fortpflanzen. Des Weiteren spricht auch die geringe erzielbare Kapazität gegen die Herstellung von Bauelementen auf einer planaren Oberfläche oder als Grabenkondensator mit einer geringen Oberflächenvergrößerung.

Bisher ist es noch nicht gelungen, monolithisch integrierte Kondensatoren mit einer effektiven Schichtdicke $d_{CET}$ herzustellen, die eine Oberflächenvergrößerung V gemäß der Formel

$$V = 20 - \frac{16}{\mu m} \cdot d_{CET}$$

bei einer für eine Serienfertigung hinreichend geringer Scheibenverbiegung auf 150mm Scheiben erlauben. Für Scheiben mit einem größeren Durchmesser ist die Oberflächenvergrößerung auf einen noch geringeren Wert begrenzt.

Bei einer Oberflächenstrukturierung durch tiefe Löcher kann die Verbiegung der Halbleiterscheibe aufgrund der Verwendung dicker dielektrischer Schichten durch größere Abstände zwischen den Löchern verringert werden. Da allerdings die Oberflächenvergrößerung mit dem Quadrat des Abstandes der Lochmittelpunkte abnimmt, ist dieses Verfahren nachteilig, wenn eine möglichst hohe Kapazität pro Chipfläche realisiert werden soll. Der minimale Durchmesser der Lochstrukturen ist dabei durch die zu integrierenden Schichtdicken der Dielektrika und oberen Kontaktelektrode begrenzt. Für einen 200 Volt-Kondensator mit 20 nm Siliziumoxid, 500 nm Siliziumnitrid und 500 nm Polysilizium werden mindestens Lochstrukturen mit einem Durchmesser von 2,04 μm benötigt.

Eine weitere Möglichkeit, die Verbiegung der Halbleiterscheibe zu reduzieren, besteht darin, zugleich auf Vorder- und Rückseite symmetrisch gegenüberliegende Vertiefungen mit ähnlicher Oberflächenvergrößerung herzustellen, wie es in US 2011/0001217 A1 beschrieben ist. Diese Methode besitzt besonders für die Realisierung von monolithisch integrierten RC-Gliedern den Nachteil, dass durch die Strukturierung und das Dielektrikum auf der Bauelementunterseite die Wärmeabfuhr aus dem Volumen der Halbleiterscheibe deutlich reduziert ist. Zudem ist für die Strukturierung der Scheibenrückseite ein zusätzlicher Photolithographie-Schritt notwendig. Dies erlaubt zwar die Herstellung von Bauelementen mit entsprechend hoher Spannungsfestigkeit, ist einer kostengünstigen Realisierung jedoch abträglich. Gleichzeitig erfordert eine derartige Lösung, dass eine Reihenschaltung zweier Kondensatoren zur Erhöhung der Spannungsfestigkeit durch den kapazitiven Spannungsteiler gleichzeitig eine gute Übereinstimmung der parasitären Leckströme (paralleler Widerstand) aufweisen sollte (ohmscher Spannungsteiler), da sich ansonsten die Spannungsverteilung überwiegend auf einen Kondensator verschieben kann, der dann den größeren Anteil oder die ganze Spannung aufnehmen müsste. Gerade aufgrund der sehr geringen Leckströme monolithisch integrierter Kondensatoren ist hier jedoch eine Abweichung der Parallelwiderstände um mehr als den Faktor 2 zu erwarten.

Des Weiteren beschreibt US 8,487,405 B2 eine Methode, um die konvexe Verbiegung einer Halbleiterscheibe mit Metall-Isolator-Metall (MIM)-Kondensatorstrukturen in tiefen Löchern zu reduzieren, welche die Verwendung zusätzlicher leitender Schichten aus kompressivem Material vorsieht. Hierbei wird jedoch durch die zusätzliche Schicht zum einen der Aufwand des Herstellungsprozesses erhöht und zum anderen zusätzliches Volumen in den Lochstrukturen beansprucht, wodurch die erreichbare Oberflächenvergrößerung reduziert wird, bzw. nicht voll ausgenutzt werden kann. In einem einfachen Herstellungsprozess, wie er für die oben beschriebenen monolithischen Kondensatoren mit 200 Volt und 600 Volt Nennspannung eingesetzt wird, wird die elektrisch leitfähige Polysiliziumschicht (Kontaktelektrode) im Prozessverlauf unterteilt, um einzelne Bauelemente auf der Halbleiterscheibe zu separieren. Aus diesem Grund kann diese Schicht nicht während des gesamten Prozesses zur Verhinderung einer Wafer-Durchbiegung beitragen.

Wünschenswert wären demnach integrierte Kondensatoren, die einen Betrieb mit einer hohen elektrischen Spannung ermöglichen und/oder eine hohe Oberflächenvergrößerung aufweisen.

Die Aufgabe der vorliegenden Erfindung besteht deshalb darin, ein Konzept zu schaffen, das integrierte Kondensatoren, mit einer hohen elektrischen Spannungsfestigkeit und/oder einer hohe Oberflächenvergrößerung ermöglicht.

Diese Aufgabe wird durch den Gegenstand der unabhängigen Patentansprüche gelöst.

Der Kerngedanke der vorliegenden Erfindung besteht darin, erkannt zu haben, dass dielektrische Schichten einer Dielektrikumsstruktur so erzeugbar sind, dass mechanische Gesamtspannungen der dielektrischen Schichten untereinander und bezüglich eines Substrats, an dem die Schichten angeordnet sind, einander entgegenwirken. Die einander entgegengesetzten mechanischen Gesamtspannungen bzw. Gesamtspannungen ermöglichen eine Reduzierung oder Verhinderung einer Durchbiegung des Halbleitersubstrats während einer Herstellung, so dass eine Integrationsdichte der Grabenstrukturen erhöht und/oder höhere Schichtdicken der Dielektrikumsschichten unter Einhaltung gegenwärtiger oder maximaler Durchbiegungen erzielbar sind. Gleichzeitig bleibt eine Prozessierbarkeit des Halbleitersubstrats erhalten. Eine hohe Dichte der Grabenstruktur ermöglicht den Erhalt einer hohen Kapazität des Kondensators. Hohe Schichtdicken der Dielektrikumsschichten ermöglichen eine hohe Spannungsfestigkeit.

Gemäß einem Ausführungsbeispiel wird bei einem Verfahren zum Herstellen eines Kondensators eine Dielektrikumsstruktur in einem Graben eines Halbleitersubstrats erzeugt. Die Dielektrikumsstruktur weist eine Mehrzahl von aneinandergrenzenden Dielektrikumsschichten auf, die einander entgegengesetzte Materialspannungen aufweisen. Eine durch eine an dem Substrat angeordnete Dielektrikumsschicht induzierte Materialspannung, die zu einer Verbiegung des Halbleitersubstrats führt, ist durch eine entgegengesetzt wirkende und durch eine zweite Dielektrikumsschicht induzierte Materialspannung reduziert oder kompensiert, was zu einer reduzierten oder verhinderten Durchbiegung des Halbleitersubstrats führt.

Gemäß einem weiteren Ausführungsbeispiel weist das Halbleitersubstrat entlang einer lateralen Richtung senkrecht zu einer Dickenrichtung eine erste mechanische Gesamtspannung, eine an dem Substrat angeordnete erste Dielektrikumsschicht eine zweite mechanische Gesamtspannung und eine zweite, an der ersten Dielektrikumsschicht angeordnete Dielektrikumsschicht eine dritte mechanische Gesamtspannung auf, die jeweils eine thermisch induzierte Materialspannung und eine intrinsisch induzierte Materialspannung umfassen. Die zweite mechanische Gesamtspannung ist größer als die erste und die dritte mechanische Gesamtspannung oder kleiner als die erste und die dritte mechanische Gesamtspannung.

Basierend auf den unterschiedlichen thermischen Ausdehnungskoeffizienten können einander entgegengesetzte Materialspannungen basierend auf unterschiedlichen thermischen Schrumpfungen bei einem Abkühlen des Halbleitersubstrats nach einem Abscheiden der Dielektrikumsschichten erhalten werden. Durch eine geeignete Wahl der Schichtdicke ist ferner die Kompensation intrinsischer Materialspannungen des Halbleitersubstrats und/oder der Dielektrikumsschichten ermöglicht.

Gemäß einem weiteren Ausführungsbeispiel wird eine Dielektrikumsschicht durch Bilden einer Teilschicht und einer zweiten Teilschicht in einem ersten bzw. einem zweiten Teilschritt gebildet. Der zweite Teilschritt ist von dem ersten Teilschritt mit einem vorbestimmten Abstand beabstandet. Das Bilden der Dielektrikumsschicht in einem ersten und einem zweiten Teilschritt ermöglicht, dass eine Ausbreitung von Fehlstellen bei einem Aufbau der amorphen Schicht zwischen den beiden Teilschritten reduziert oder verhindert ist, so dass die Dielektrikumsschicht eine höhere elektrische Zuverlässigkeit aufweist.

Gemäß einem weiteren Ausführungsbeispiel weist ein Kondensator eine Dielektrikumsstruktur in einem Graben eines Halbleitersubstrats auf, wobei die Dielektrikumsstruktur eine Mehrzahl von aneinandergrenzenden Dielektrikumsschichten aufweist, die einander entgegengesetzte Materialspannungen aufweisen. Dies ermöglicht hohe Dicken der Dielektrikumsstruktur und eine hohe Anzahl von Freiheitsgraden basierend auf einer Materialwahl für jede Dielektrikumsschicht sowie einer Wahl der Reihenfolge der Dielektrikumsschichten.

Gemäß einem weiteren Ausführungsbeispiel wird ein erfindungsgemäß hergestellter Kondensator in einem Leistungsmodul verwendet. Dies ermöglicht die Implementierung von hochintegrierten, das heißt einem geringen Bauraum bei hoher Funktionalität aufweisenden Koppelkondensatoren oder Bedämpfungselementen.

Weitere vorteilhafte Ausführungsbeispiele sind der Gegenstand der abhängigen Patentansprüche.

Bevorzugte Ausführungsbeispiele der vorliegenden Erfindung werden nachfolgend Bezug nehmend auf die beiliegenden Zeichnungen erläutert. Es zeigen:

Fig. 1 ein schematisches Ablaufdiagramm eines Verfahrens zum Herstellen eines Kondensators gemäß einem Ausführungsbeispiel;

Fig. 2 ein schematisches Ablaufdiagramm eines Verfahrens zum Erzeugen der Dielektrikumsstruktur, bei dem eine Dielektrikumsschicht in zwei Teilschritten angeordnet wird gemäß einem Ausführungsbeispiel;

Fig. 3 ein schematisches Ablaufdiagramm eines Verfahrens zur Erzeugung der Dielektrikumsstruktur mit einer ersten, zweiten und dritten Dielektrikumsschicht gemäß einem Ausführungsbeispiel;

Fig. 4 einen Ausschnitt einer schematischen Seitenschnittansicht eines Kondensators, wie er durch das Verfahren aus Fig. 1 herstellbar ist gemäß einem Ausführungsbeispiel;

Fig. 5 einen Ausschnitt einer schematischen Seitenschnittansicht eines Kondensators, bei dem, verglichen mit dem Kondensator aus Fig. 4, eine Dielektrikumsstruktur eine dritte Dielektrikumsschicht umfasst gemäß einem Ausführungsbeispiel;

Fig. 6 einen Ausschnitt einer schematischen Seitenschnittansicht eines Kondensators, bei dem eine Dielektrikumsschicht der Dielektrikumsstruktur mittels zweier Teilschichten gebildet ist gemäß einem Ausführungsbeispiel;

Fig. 7a eine schematische Seitenschnittansicht eines Zwischenprodukts eines Kondensators, bei dem an einer ersten Hauptseitenoberfläche eine Dielektrikumsstruktur und an einer zweiten Hauptseitenoberfläche eine weitere Dielektrikumsstruktur gebildet ist gemäß einem Ausführungsbeispiel;

Fig. 7b eine schematische Aufsicht auf einen Wafer mit einer Vielzahl von in Fig. 7a beschriebenen Kondensatoren vor einer Trennung der einzelnen Komponenten;

Fig. 8 beispielhaft einen (gemessenen) Verlauf einer Durchbiegung eines Wafers während einer Herstellung von Kondensatoren gemäß einem Ausführungsbeispiel;

Fig. 9 eine schematische Darstellung verschiedener (gemessener) Durchbiegungen des Wafers, bei denen im Vergleich zu den Darstellungen in der Fig. 8 die zweite Dielektrikumsschicht in etwa doppelt so dick ausgeführt ist, gemäß einem Ausführungsbeispiel; und

Fig. 10 eine schematische perspektivische Ansicht einer Verbiegung eines Silizium-Wafers mit einem Durchmesser von 150 mm gemäß dem Stand der Technik.

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

Nachfolgend wird Bezug genommen auf intrinsische und thermische Materialspannungen Δ. Thermische Materialspannungen Δ werden so erläutert, dass basierend auf positiven thermischen Ausdehnungskoeffizienten a Materialien bei einer Abkühlung, gegenüber einer benachbarten Schicht und/oder einem (Halbleiter-)Substrat schrumpfen. Es versteht sich, dass eine Erwärmung zu einer Ausdehnung führen kann. Ferner können die nachfolgenden Ausführungen auch so verstanden werden, dass Materialen eine vernachlässigbare Verformung bei Erwärmung oder Abkühlung ausführen ,d. h., der Ausdehnungskoeffizient ist in etwa null. Alternativ kann der thermische Ausdehnungskoeffizient auch negativ sein, etwa für Zinkcyanid oder Zirconiumwolframat, so dass die nachfolgenden Erläuterungen bezüglich der Wärmeausdehnung diesbezüglich wechselseitig vertauschbar sind.

Nachfolgend wird ferner Bezug genommen auf Graben oder Grabenstrukturen eines integrierten MIS-Kondensators (MIS = Metal-Insulator-Semiconductor, Metall-Isolator-Hableiter), eines so genannten 3D-Kondensators. Als Graben können hierunter auch Loch-, Kerben- oder Säulenstrukturen verstanden werden, die eine zweidimensionale laterale Ausdehnung entlang einer Substratoberfläche und eine Ausdehnung entlang einer Tiefenrichtung senkrecht zu der Substratoberfläche aufweisen. Ferner kann eine Grabenstruktur einen oder mehrere Gräben aufweisen. Mehrere Gräben können voneinander unterschiedlich bezogen auf Ausdehnung, Tiefe oder Form ausgestaltet sein.

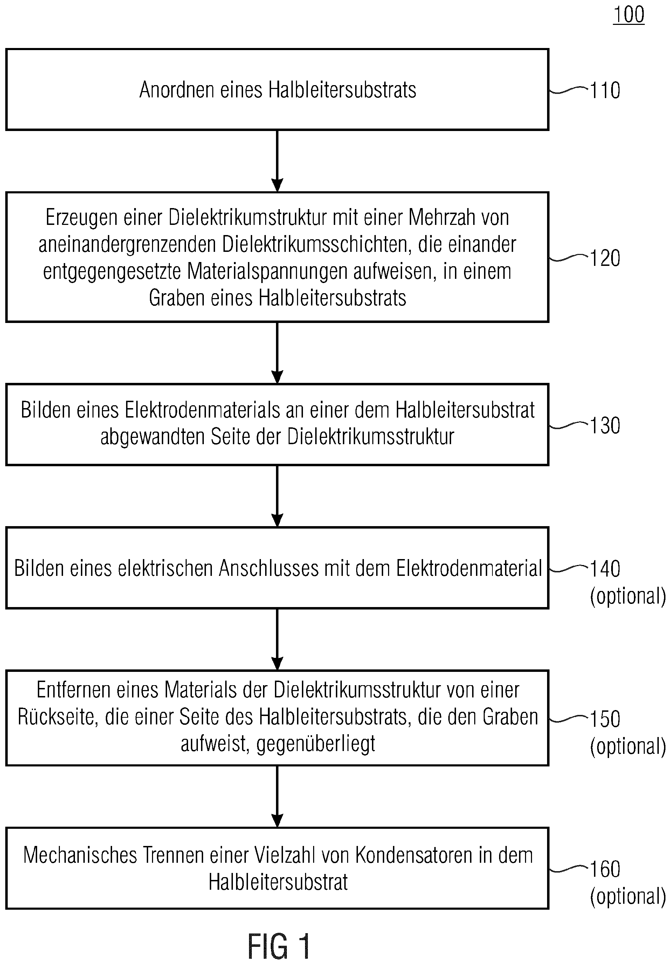

Fig. 1 zeigt ein schematisches Ablaufdiagramm eines Verfahrens 100 zum Herstellen eines Kondensators. In einem Schritt 110 wird ein Halbleitersubstrat, das eine oben beschriebene Grabenstruktur aufweist, angeordnet. Bei dem Halbleitersubstrat kann es sich beispielsweise um einen Silizium-Wafer handeln, mittels dessen eine Vielzahl von Halbleiter-basierten Kondensatoren hergestellt werden soll. Vorstellbar sind beispielsweise Silizium-Wafer mit einem Durchmesser von 100 mm, 150 mm oder 200 mm oder anderen, insbesondere größeren Werten. Alternativ kann es sich bei dem Halbleitersubstrat auch um dotierte oder undotierte organische oder anorganische Halbleitermaterialien handeln. Ferner kann das Halbleitersubstrat auch in anderen Formen als der eines Wafers angeordnet werden, beispielsweise in bereits separierten Wafer-Teilen (ggf. nach einem Dicing). Vorzugsweise weist das Halbleitersubstrat mehrere Gräben auf, da diese zu einer Oberflächenvergrößerung und mithin zu einer höheren Funktionsdichte des Kondensators führen können. Der Graben oder eine alternativ mehrere Gräben umfassende Grabenstruktur führt zu einer Oberflächenvergrößerung des Halbleitersubstrats bezüglich eines Hauptoberflächenbereichs (etwa eine Ober- oder Unterseite des Wafers), die den Graben oder die Grabenstruktur aufweist. Die Grabenstruktur kann mehrere Gräben mit mehreren Löchern, Säulen, Kerben oder eine Kombination daraus aufweisen.

In einem Schritt 120 wird eine Dielektrikumsstruktur mit einer Mehrzahl von aneinandergrenzenden Dielektrikumsschichten in dem Graben oder einer Grabenstruktur des Halbleitersubstrats erzeugt. Die Mehrzahl von aneinandergrenzenden Dielektrikumsschichten weisen eine einander entgegengesetzte Materialspannung, d. h. mechanische Gesamtspannung, auf.

Die Materialspannungen (mechanische Gesamtspannungen) können thermisch induzierte Materialspannungen und/oder intrinsische Materialspannungen umfassen. Die intrinsischen Materialspannungen können beispielsweise durch eine Gitter-Fehlanpassung innerhalb einer Gitterstruktur des Halbleitersubstrats oder einer dielektrischen Schicht oder zwischen Gitterstrukturen aneinandergrenzender Schichten zumindest teilweise induziert werden. Beispielsweise kann ein Dotierstoff, wie Bor oder Phosphor, zu einem dotierten Stoff, wie etwa Silizium, zu einer veränderten Gitterstruktur des dotierten Stoffs führen. Alternativ oder zusätzlich können unterschiedliche Gitter- oder Korngrößen benachbarter Schichten bei einem Aufwachsen einer Schicht an einer anderen zu Materialspannungen führen. Thermisch induzierte Materialspannungen können beispielsweise dadurch resultieren, dass eine Dielektrikumsschicht bei einer Temperatur abgeschieden wird, die größer als die Raumtemperatur ist. Bei einer Abkühlung und bei verschiedenen thermischen Ausdehnungskoeffizienten des Halbleitersubstrats und der Dielektrikumsschicht (oder weiterer Dielektrikumsschichten) können die jeweiligen Materialien einen voneinander verschiedenen Schrumpfungsfaktor, d. h., thermischen Ausdehnungskoeffizienten, aufweisen. Die voneinander verschiedene Schrumpfung führt zu den thermisch induzierten Materialspannungen. Thermisch induzierte und intrinsische Materialspannungen werden nachfolgend gemeinsam als Gesamtspannung bezeichnet, wobei einer der beiden Anteile auch einen vernachlässigbaren Wert oder Anteil, etwa von 0, aufweisen kann. Auch kann ein Temperaturwechsel zwischen dem Abscheiden verschiedener Schichten zu thermischen Materialspannungen führen.

Vereinfacht ausgedrückt kann die Dielektrikumsstruktur so erzeugt werden, dass sie die Grabenstruktur und ggf. das Substrat außerhalb des Grabens flächig bedeckt. Eine erste Dielektrikumsschicht der Dielektrikumsstruktur kann beispielsweise Siliziumoxid umfassen. Eine zweite Dielektrikumsschicht der Dielektrikumsstruktur kann beispielsweise Siliziumnitrid umfassen. Alternativ kann eine der Dielektrikumsschichten oder eine weitere Dielektrikumsschicht auch andere dielektrische Materialien umfassen, beispielsweise ein Titanoxid, ein Tantaloxid, ein Hafniumoxid, ein Aluminiumoxid, ein Lanthanoxid oder dergleichen. Die Dielektrikumsstruktur kann beispielsweise erzeugt werden, indem auf dem Halbleitersubstrat, wenn dieses Silizium umfasst, mittels einer thermischen Oxidation in einer Sauerstoff-Umgebung das Silizium oxidiert wird und so eine Siliziumoxidschicht erzeugt wird. Die thermische Oxidation kann als trockene oder feuchte bzw. nasse Oxidation durchgeführt werden. Die Oxidation kann bei einer Temperatur zwischen 800 °C und 1200 °C, zwischen 900 °C und 1100 °C oder in einem Temperaturbereich zwischen 1000 °C und 1070 °C, bevorzugt bei in etwa 1050 °C durchgeführt werden. Eine Schichtdicke der Siliziumoxidschicht kann zumindest 200 nm, zumindest 300 nm (beispielsweise 333 nm) oder mehr betragen. Eine höhere Temperatur, bei der die Oxidation ausgeführt wird, kann für zunehmende Schichtdicken vorteilhaft sein.

An der Siliziumoxidschicht kann eine zweite Dielektrikumsschicht, etwa umfassend Siliziumnitrid, erzeugt werden. Siliziumnitrid kann beispielsweise mittels einer chemischen Gasphasenabscheidung erzeugt werden. Die chemische Gasphasenabscheidung kann bei Niederdruck (engl.: Low Pressure Chemical Vapor Deposition - LPCVD) erzeugt werden. Dies kann beispielsweise unter Verwendung von Dichlorsilan und Ammoniak in einem Temperaturbereich von beispielsweise 700 °C bis 900 °C, 720 °C bis 850 °C oder 750 °C bis 800 °C durchgeführt werden. Diese Temperatur kann somit niedriger sein als eine Temperatur, bei der das Siliziumoxid gebildet wird. Die Siliziumnitridschicht kann beispielsweise mit einer Dicke von zumindest 400 nm, zumindest 500 nm oder von zumindest 1000 nm abgeschieden werden. Alternativ zu LPCVD kann auch eine plasmaunterstützte Gasphasenabscheidung (Plasma Enhanced Chemical Vapor Deposition - PECVD), eine Hochdruck-Gasphasenabscheidung (High Pressure Chemical Vapor Deposition - HPCVD), eine Atmosphärendruck-Gasphasenabscheidu (Atmospheric Pressure Chemical Vapor Deposition - APCVD), eine physikalische Gasphasenabscheidung (Physical Vapor Deposition - PVD) oder ein anderes Verfahren genutzt werden. Ferner kann Silizium(di)oxid eine andere Gitterstruktur, d. h., einen voneinander verschiedenen Atomabstand in der amorphen Atomstruktur aufweisen als Siliziumnitrid und/oder Silizium.

Basierend auf intrinsischen Materialspannungen und/oder einer thermischen Verformung bei einem Abkühlen des Materials nach der Oxidation kann das Halbleitersubstrat sowie die Oxidschicht eine Verformung oder Verbiegung, etwa konvex bzw. konkav, aufweisen. Mechanische Spannungen der Siliziumnitridschicht wirken mechanischen Spannungen der Siliziumoxidschicht entgegen bzw. sind diesen entgegengerichtet.

Die entgegenwirkenden Materialspannungen führen zu einer geringeren Durchbiegung des Halbleitersubstrats während des Verfahrens 100. Dies ermöglicht eine höhere Oberflächenvergrößerung und/oder dickere Dielektrikumsschichten, die jeweils wieder zu einer stärkeren Durchbiegung führen würden, so dass eine maximale Durchbiegung, etwa basierend auf Prozessparametern, weiterhin einhaltbar ist.

Siliziumnitrid kann einen Temperaturausdehnungskoeffizienten a in einem Bereich von beispielsweise 3,3 bis 3,5·10$^{-6}$/K aufweisen. Dahingegen weist Siliziumoxid typischerweise einen Temperaturausdehnungskoeffizienten a von ca. 5,6·10$^{-7}$/K auf. Siliziumoxid schrumpft somit in einem geringerem Umfang als Siliziumnitrid, wenn beide Materialien abgekühlt werden, was zu thermischen Materialspannungen zwischen den Schichten führt. Umfasst das Halbleitersubstrat Silizium, welches einen Temperaturausdehnungskoeffizienten a in einem Bereich von ca. 2,6·10$^{-6}$/K aufweist, so weist in vorangegangenem Ausführungsbeispiel die an dem Halbleitersubstrat angeordnete erste Dielektrikumsschicht einen geringeren Temperaturausdehnungskoeffizienten auf als das Halbleitersubstrat und als die an der ersten Dielektrikumsschicht angeordnete zweite Dielektrikumsschicht. Somit kann beispielsweise an dem Halbleitersubstrat auch eine Siliziumnitridschicht und an dem Siliziumnitrid die Siliziumoxidschicht angeordnet werden. Ferner können andere oder weitere Dielektrikumsschichten der Dielektrikumsstruktur erzeugt werden, wobei vorzugsweise Materialspannungen zweier "äußerer" Schichten (beispielsweise Substrat und zweite Dielektrikumsschicht) einer Materialspannung einer inneren Schicht (beispielsweise erste Dielektrikumsschicht) entgegenwirken.

Gemäß alternativen Ausführungsbeispielen dass eine Materialspannung einer ersten und einer vierten, fünften oder höherzahligen Dielektrikumsschicht, die in dieser Reihenfolge an dem Substrat abgeschieden werden, einer Materialspannung einer zweiten und/oder dritten Dielektrikumsschicht entgegenwirken.

In einem Schritt 130 des Verfahrens 100 wird ein Elektrodenmaterial an der Dielektrikumsstruktur abgeschieden. Wird eine Anordnung des Halbleitersubstrats und der Dielektrikumsstruktur als Stapel bezeichnet, bei dem das Substrat beispielsweise die Unterseite bildet, so wird das Elektrodenmaterial an der Oberseite des Stapels abgeschieden, das bedeutet auf der dem Halbleitersubstrat abgewandten Seite der Dielektrikumsstruktur. Bei dem Elektrodenmaterial kann es sich beispielsweise um Polysilizium (polykristallines Silizium) das nachträglich dotiert wird oder um in-situ-dotiertes Polysilizium handeln, das beispielsweise bei 570 °C und mithin einer gegenüber den obigen Schritten weiter erniedrigten Temperatur abgeschieden wird. Alternativ kann das Polysilizium auch mittels eines Diffusionsprozesses, etwa ein POCl$_3$-Prozess, und/oder bei gegenüber vorangegangenen Schritten erhöhten Temperaturen (bspw. in etwa 950°C) angeordnet werden. Ebenso ist eine konforme Abscheidung einer Metallschicht vorstellbar. Das Elektrodenmaterial ermöglicht eine flächige Kontaktierung der topographisch unebenen Dielektrikumsstruktur. Werden die Dielektrikumsschichten mit einer homogenen Schichtdicke in dem Graben bzw. in oder an der Grabenstruktur abgeschieden, so weist die Oberfläche der Dielektrikumsstruktur im Wesentlichen ähnliche oder geometrisch ähnliche Höhenunterschiede auf, wie die Grabenstruktur. Das Elektrodenmaterial kann ebenfalls vergleichbare Höhenunterschiede aufweisen oder die Höhenunterschiede ganz oder teilweise ausgleichen, d. h. die verbleienden Gräben ganz oder teilweise ausfüllen. Ein ggf. zusätzlicher metallischer Kontakt ermöglicht den Erhalt einer ebenen Oberfläche, die in einem optionalen Schritt 140 hergestellt werden kann. Hierfür kann eine metallische Schicht an der Oberfläche der Dielektrikumsstruktur angeordnet werden. Verfüllt das Elektrodenmaterial die Dielektrikumsstruktur nicht vollständig, so kann der metallische Kontakt daraus verbleibende Höhenunterschiede ausgleichen. Alternativ kann auch eine Oberfläche eines Kondensators eine unebene Oberfläche aufweisen. Alternativ kann das Elektrodenmaterial in dem Schritt 140 auch lokal elektrisch kontaktiert werden, wobei die Kontaktierung vorzugsweise mit geringem ohmschen Widerstand ausgeführt wird. Dies kann durch metallische Kontaktierung erreicht werden. Bspw. ermöglicht eine Aluminiumschicht mit einer Dicke von in etwa 3 $\mu$m bis 4 $\mu$m eine elektrische Kontaktierung mittels Bonddrähten.

Die Erzeugung der Dielektrikumsstruktur durch Dielektrikumsschichten, die einander entgegengesetzte Materialspannungen aufweisen, kann dazu führen, dass eine maximale Durchbiegung des Halbleitersubstrats während der Prozessierung unterhalb einer vordefinierten Obergrenze bleibt. Die vordefinierte Obergrenze kann beispielsweise durch Auslenkungsamplituden, bei denen eine oder mehrere Schichten des Halbleitersubstrats und/oder der Dielektrikumsstruktur Schäden aufweisen, etwa durch Bruch, beeinflusst sein. Alternativ oder zusätzlich kann die maximale Durchbiegung durch externe Anforderungen beeinflusst sein, beispielsweise eine Aufnahmemöglichkeit einer Hebe- oder Saugvorrichtung. Eine Saugvorrichtung zur Aufnahme des Halbleitersubstrats kann beispielsweise ausgebildet sein, um einen Silizium-Wafer mit einer maximalen Durchbiegung von 350 $\mu$m bezogen auf einen Mittelpunkt zu einem äußeren Rand des Wafers mittels Unterdruck zu transportieren. Weist das Halbleitersubstrat und/oder die Dielektrikumsstruktur eine höhere Durchbiegung auf, so kann die Erzeugung des Unterdrucks beispielsweise verhindert oder reduziert sein.

Das Verfahren 100 umfasst einen optionalen Schritt 150, bei dem Material der Dielektrikumsstruktur von einer der Grabenstruktur abgewandten Seite des Halbleitermaterials entfernt wird. Die der Grabenstruktur abgewandte Seite kann als eine Rückseite betrachtet werden, wenn die Grabenstruktur an oder in der Vorderseite des Halbleitersubstrats angeordnet ist. Weist das Halbleitersubstrat den Graben an einer Seite auf, so kann Material der Dielektrikumsschichten während einer Abscheidung derselben an beiden oder allen Seiten des Halbleitersubstrats abgeschieden werden. Zur elektrischen Kontaktierung der Rückseite und/oder zur Verringerung der Baugröße kann nicht benötigtes Material von der Rückseite entfernt werden. Alternativ kann das Halbleitersubstrat die Grabenstruktur bzw. einen Graben an beiden Hauptseiten (Vorder- und Rückseite) aufweisen. In diesem Fall kann eine Entfernung des Materials der Dielektrikumsstruktur von der Rückseite und mithin der Schritt 150 entfallen. Alternativ kann eine Entfernung des Materials von der Rückseite auch entfallen, wenn das Material nicht störend bzw. angestrebt ist. In diesem Fall können Prozesskosten reduziert werden. So kann auf der Rückseite ein ggf. mittels eines Lötvorgangs elektrisch kontaktierbarer Schichtstapel ganzflächig (strukturiert oder unstrukturiert) angeordnet werden. Das Material kann bspw. angestrebt sein, wenn das Halbleitersubstrat an der Rückseite ebenfalls zumindest einen Graben aufweist, der von der Dielektrikumsstruktur bedeckt werden soll. Die Schritte 140 und 150 können in einer beliebigen Reihenfolge ausgeführt werden.

In einem optionalen Schritt 160 des Verfahrens 100 werden eine Vielzahl von Kondensatoren in dem Halbleitersubstrat mechanisch getrennt. Ist das Halbleitersubstrat beispielsweise der Silizium-Wafer, so können eine Vielzahl, beispielsweise mehr als 100, mehr als 500 oder gar mehr als 1000 Kondensatoren je Wafer (gleichzeitig) gefertigt werden. In dem Schritt 160 können diese mechanisch voneinander getrennt (Dicing) werden, beispielsweise mittels eines Schneid-, Ätz- oder Bruch-Vorgangs oder durch thermische Laserseparation.

Das Halbleitersubstrat und die Dielektrikumsschichten können jeweils eine intrinsische Materialspannung aufweisen. Thermisch induzierte Materialspannungen zwischen den Materialien aneinandergrenzender Schichten können basierend auf der Wechselwirkung voneinander verschiedener thermischen Ausdehnungskoeffizienten der Schichtmaterialien zumindest teilweise induziert werden. Schichtdicken von Schichten der Dielektrikumsstruktur können mithin basierend auf der jeweiligen intrinsischen Materialspannung sowie den thermischen Ausdehnungskoeffizienten gewählt werden, wobei durch die zumindest teilweise Kompensation der Verformung der Gesamtstruktur eine hohe Schichtdicke unter Verwendung von Materialien mit hohen Dielektrizitätszahlen ermöglicht wird. Dies ermöglicht eine Realisierung von halbleiterbasierten Kondensatoren, die sowohl eine hohe Kapazität, bspw. mit einer Integrationsdichte von $\geq$ 0,5 nF/mm$^2$, $\geq$ 1,0 nF/mm$^2$ oder $\geq$ 1,25 nF/mm$^2$ als auch eine hohe Dauerbetriebsspannung (Betriebsspannung, mit der ein schadarmer Dauerbetrieb des Kondensators ermöglicht ist) von $\geq$ 300 V, $\geq$ 400 V oder $\geq$ 600 V aufweisen. Basierend auf der geringen Verbiegung der Gesamtstruktur kann ferner eine hohe Oberflächenvergrößerung des Halbleitersubstrats mittels des Grabens bzw. der Grabenstruktur erreicht werden, was zu einer weiteren Erhöhung der Kapazität des erzeugten Kondensators führt.

Wird das Halbleitersubstrat beispielsweise als Wafer bereitgestellt, so kann die Dielektrikumsstruktur über mehrere oder alle Kondensatorbereiche von Kondensatoren (Bereiche, die später einen Kondensator bilden werden) gemeinsam hinweg sowie über Zwischenbereiche dazwischen gebildet werden, so dass eine Dielektrikumsstruktur mehrere oder alle der Kondensatoren bedeckt. Bei einem rund ausgeführten Wafer mit einem Durchmesser von 150 mm kann die konvexe oder konkave Verformung vorzugsweise in einem Umfang von $\leq 350\,\mu m$, $\leq 300\,\mu m$ oder $\leq 250\,\mu m$ gehalten werden. Wafer, die einen größeren Durchmesser aufweisen, können auf eine derartige Auslenkung in einem inneren Bereich, der einen Durchmesser von 150 mm umfasst, prozessiert werden. Alternativ kann die maximale Auslenkung der konkaven oder konvexen Verformung von $\leq 350\,\mu m$, $\leq 300\,\mu m$ bzw. $\leq 250\,\mu m$ auf die gesamte Ausdehnung des Wafers bezogen werden. Das bedeutet, dass bei Wafern mit Durchmessern von mehr als 150 mm eine Gesamt-Verformung (Durchbiegung) in einem oben genannten Umfang gehalten wird, so dass bspw. pro gefertigten Bauteil , d. h. pro Flächeneinheit, eine relativ zu einem Wafer mit 150 mm Durchmesser geringere Verbiegung zulässig ist.

Das Verfahren 100 kann weitere Schritte aufweisen, beispielsweise eine Anordnung einer elektrisch isolierenden Schicht an dem Elektrodenmaterial oder an einer metallischen Schicht, die das Elektrodenmaterial bedeckt. Eine elektrisch isolierende Schicht ermöglicht eine Passivierung des Bauteils gegenüber seinem Umfeld.

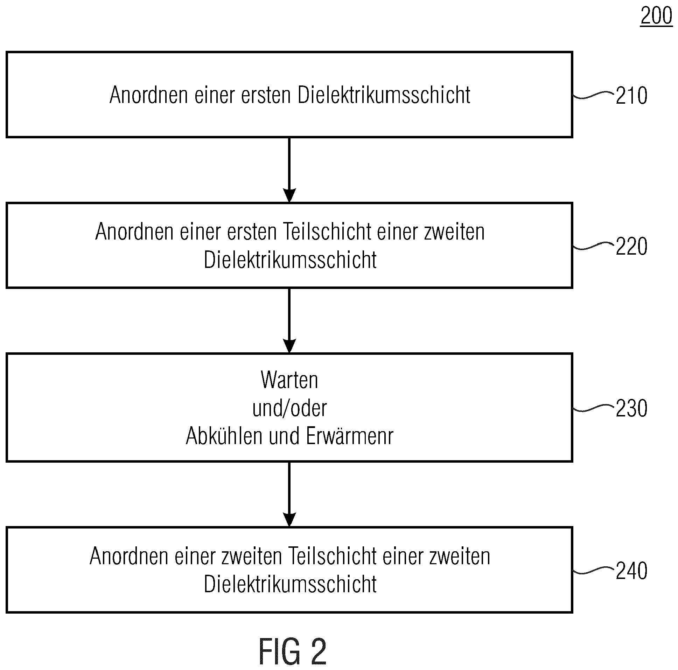

Fig. 2 zeigt ein schematisches Ablaufdiagramm eines Verfahrens 200 zum Erzeugen der Dielektrikumsstruktur. Das Verfahren 200 kann beispielsweise Teil des Schritts 120 sein. In einem Schritt 210 wird die erste Dielektrikumsschicht, etwa Silizium(di)oxid angeordnet. In einem Schritt 220 wird eine erste Teilschicht einer zweiten Dielektrikumsschicht angeordnet. Bei der zweiten Dielektrikumsschicht kann es sich beispielsweise um eine Schicht umfassend ein von Siliziumoxid verschiedenes Material wie Siliziumnitrid oder Aluminiumoxid handeln. In einem Schritt 230 wird ein vorbestimmter Abstand zu einem Schritt 240 überbrückt, in welchem eine zweite Teilschicht der zweiten Dielektrikumsschicht angeordnet wird. Das heißt, dass die zweite Dielektrikumsschicht mittels einer ersten Teilschicht in einem Teilschritt 220 und mittels einer zweiten Teilschicht in einem Teilschritt 240 angeordnet wird, wobei der erste Teilschritt und der zweite Teilschritt durch den Schritt 230 voneinander beabstandet sind.

In dem Schritt 230 kann ein Abkühlen und ein anschließendes Erwärmen, etwa von einer Prozesstemperatur hin zu einer niedrigeren Temperatur (beispielsweise eine um 100 °C oder mehr reduzierte Temperatur, Raumtemperatur oder niedrigere Temperaturen) und ein anschließendes Erwärmen zurück auf Prozesstemperatur erfolgen. Zwischen dem Abkühlen und dem Erwärmen kann auch ein Zeitabschnitt angeordnet sein, in welchem die Materialien bei einer Temperatur, auf die das Material abgekühlt wird, verharrt. Alternativ kann der Schritt 230 auch lediglich ein Warten, d.h. ein Verharren bei Prozesstemperatur ohne eine Abscheidung oder Anordnung von dielektrischem Material umfassen. Ein Warten kann beispielsweise eine Zeitdauer von zumindest 30 Minuten, 60 Minuten oder 120 Minuten umfassen. Ein Verharren bei Prozesstemperatur ohne Anordnung von dielektrischem Material (oder durch Anordnung einer geringeren Menge davon) kann eine Ausheilung des dielektrischen Materials der Dielektrikumsschicht ermöglichen. Alternativ kann die Dielektrikumsschicht von der Prozesstemperatur ausgehend und ohne eine Abscheidung von dielektrischem Material erwärmt und anschließend wieder auf Prozesstemperatur abgekühlt werden. Alternativ kann die zweite Dielektrikumsschicht auch in einer Anzahl von einer oder mehr als zwei Teilschritten, d.h. Teilschichten, angeordnet werden.

Die Anordnung der zweiten Dielektrikumsschicht in zwei oder mehr Teilschichten ermöglicht eine Reduzierung oder Verhinderung einer Ausbreitung von Fehlstellen in einem Material der Dielektrikumsschicht. Fehlstellen können während einer Abscheidung oder Erzeugung beispielsweise basierend auf voneinander verschiedenen Gitterstrukturen und/oder Inhomogenitäten eines abgeschiedenen Schichtmaterials entstehen. Die Fehlanpassungen oder Inhomogenitäten (Fehlstellen) können sich bei einer zunehmenden Schichtdicke, etwa durch kontinuierliches Aufwachsen der Schicht, fortsetzten und/oder verstärken. Jeder der Teilschichte kann als eine neu angeordnete Schicht verstanden werden, die neue und zum Teil andere Fehlstellen(ursprünge) aufweist. Bei einer CVD-Abscheidung entstehen diese bspw. auf Grund von Nukleationsvorgängen zu Beginn der Abscheidereaktion auf der Halbleiterscheibe. Sind ein Ende einer ersten Fehlstelle und ein Anfang einer zweiten, neuen Fehlstelle voneinander beabstandet, so ist die erste Fehlstelle unterbrochen. Mittels der zwei oder mehr voneinander beabstandeten Teilschritte 220 und 240 kann eine Fehlerfortpflanzung zwischen den Teilschritten reduziert oder verhindert werden. Vereinfacht ausgedrückt ermöglicht die Anordnung der zweiten Teilschicht die Anordnung einer weiteren Schicht umfassend das gleiche Material mit neuen Fehlstellen, wobei die Fehlstellen der vorherigen Teilschicht in ihrer Ausbreitung gehemmt oder verhindert sind. Alternativ kann auch die erste Dielektrikumsschicht mittels zweier Teilschichten gebildet werden. Eine Anordnung einer Dielektrikumsschicht in Teilschichten kann auch in mehr als zwei Teilschichten erfolgen.

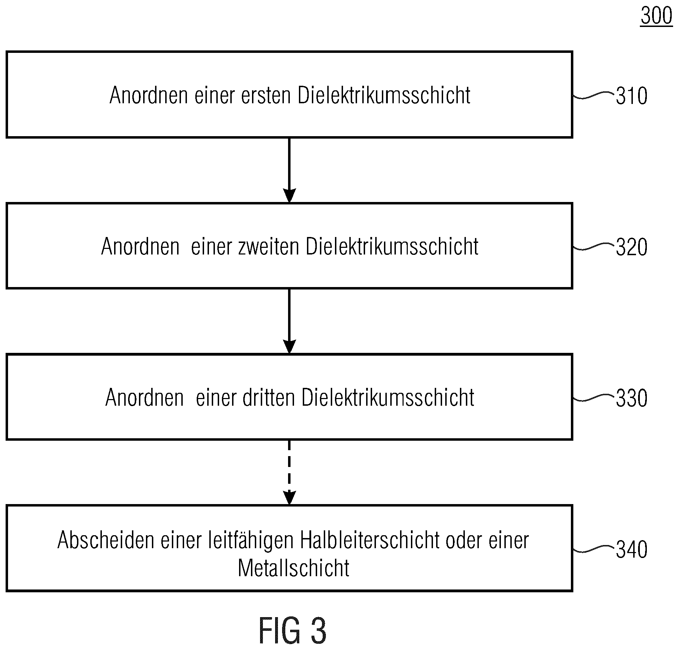

Fig. 3 zeigt ein schematisches Ablaufdiagramm eines Verfahrens 300 zur Erzeugung der Dielektrikumsstruktur. Schritte 310, 320 und/oder 330 des Verfahrens 300 können beispielsweise teilweise in dem Schritt 120 des Verfahrens 100 ausgeführt werden.

In dem Schritt 310 wird eine erste Dielektrikumsschicht angeordnet. In dem Schritt 320 wird eine zweite Dielektrikumsschicht angeordnet. In dem Schritt 330 wird eine dritte Dielektrikumsschicht angeordnet. Vorzugsweise weisen die erste, zweite und dritte Dielektrikumsschicht einander entgegengesetzte Materialspannungen auf, d.h. die erste Dielektrikumsschicht weist Materialspannungen auf, die der zweiten Dielektrikumsschicht entgegengesetzt sind und die zweite Dielektrikumsschicht weist Materialspannungen auf, die der dritten Dielektrikumsschicht entgegengesetzt sind. Alternativ kann auch die erste Dielektrikumsschicht Materialspannungen aufweisen, die Materialspannungen der zweiten und dritten Dielektrikumsschicht entgegengesetzt sind oder die dritte Dielektrikumsschicht kann Materialspannungen aufweisen, die der ersten und zweiten Dielektrikumsschicht entgegengesetzt sind. Das bedeutet, dass eine Dielektrikumsschicht Materialspannungen aufweisen kann, die einer oder mehreren anderen Dielektrikumsschichten bzw. Materialspannungen des Halbleitersubstrats entgegengesetzt sind.

Alternativ können in dem Schritt 330 oder weiteren Schritten auch weitere Dielektrikumsschichten angeordnet bzw. erzeugt werden. In einem optionalen Schritt 340 wird eine leitfähige Halbleiterschicht oder alternativ eine Metallschicht an der dritten oder letzten Dielektrikumsschicht abgeschieden. Der Schritt 340 kann beispielsweise als Teil des Schritts 140 ausgeführt werden. Beispielsweise kann ein Material umfassend Polysilizium an der dritten oder letzten Dielektrikumsschicht angeordnet werden. Alternativ und wie durch den gestrichelten Pfeil zwischen dem Schritt 330 und dem Schritt 340 angedeutet, kann auch ein anderer Schritt ausgeführt werden, beispielsweise der Schritt 150 oder 160.

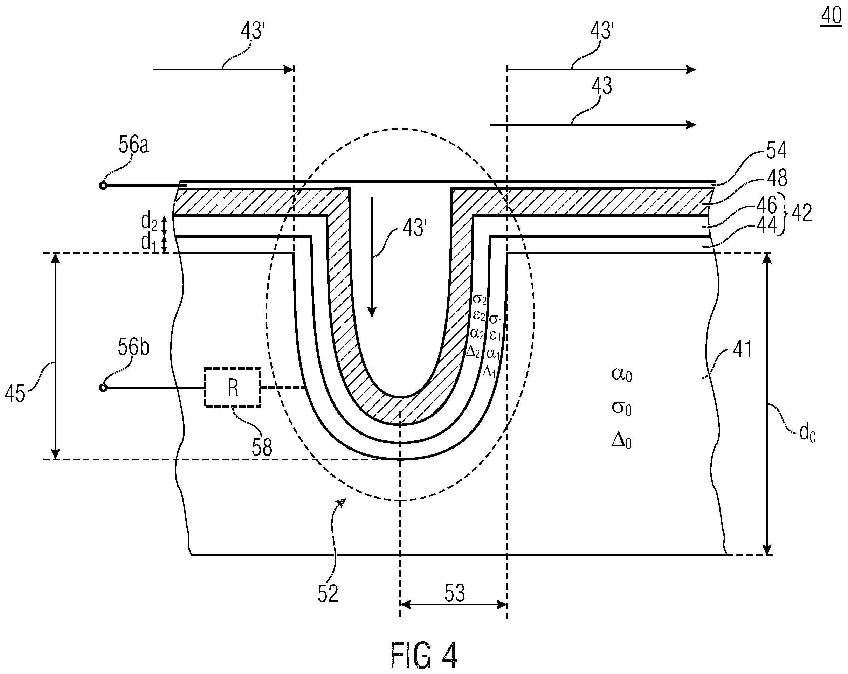

Fig. 4 zeigt einen Ausschnitt einer schematischen Seitenschnittansicht eines Kondensators 40, wie er durch das Verfahren 100 herstellbar ist. Der Kondensator 40 umfasst das Halbleitersubstrat 41 und die Dielektrikumsstruktur 42 umfassend eine erste Dielektrikumsschicht 44 und eine zweite Dielektrikumsschicht 46, die in dieser Reihenfolge an dem Halbleitersubstrat 41 angeordnet sind. Der Kondensator 40 umfasst ferner ein Elektrodenmaterial 48, das an der zweiten Dielektrikumsschicht 46 angeordnet ist und diese flächig bedeckt. Dabei "füllt" das Elektrodenmaterial 48 einen Graben 52, der in dem Halbleitermaterial 41 gebildet und von der Dielektrikumsstruktur 42 bedeckt ist, teilweise aus, so dass eine Oberfläche der zweiten Dielektrikumsschicht 46 flächig bedeckt ist. An dem Elektrodenmaterial 48 ist eine metallische Schicht 54 umfassend zumindest ein metallisches Material, wie Gold, Silber, Kupfer, Platin, Aluminium oder dergleichen zur Kontaktierung des Elektrodenmaterials 48 angeordnet. Alternativ kann das Elektrodenmaterial 48 ein verbleibendes Grabenvolumen auch vollständig ausfüllen. Das Elektrodenmaterial 48 kann bspw. ein Halbleitermaterial, wie etwa Polysilizium umfassen. Alternativ oder zusätzlich kann das Elektrodenmaterial 48 auch metallische Materialien umfassen, wie etwa Gold, Silber, Platin, Kupfer, Aluminium oder dergleichen. Umfasst das Elektrodenmaterial 48 ganz oder vollständig metallische Materialien, so kann das Elektrodenmaterial 48 und die metallische Schicht 54 einstückig gebildet sein und/oder lediglich eine der Schichten angeordnet werden, um die dielektrische Struktur 42 elektrisch zu kontaktieren. Vereinfacht ausgedrückt kann eine Kontaktierung der dielektrischen Struktur 42 mittels der metallischen Schicht 54 und einer optionalen Halbleiterschicht zwischen derselben und der dielektrischen Struktur 42 erfolgen.

An einer Rückseite des Halbleitersubstrats 41, d.h. an einer Seite, die der Dielektrikumsstruktur 42 abgewandt ist, ist eine Dielektrikumsstruktur entfernt oder nicht angeordnet.

Zwischen einem Anschluss 56a und einem Anschluss 56b des Kondensators 40 ist eine elektrische Spannung anlegbar. Der Anschluss 56a ist mit der metallischen Schicht 54 verbunden. Der Anschluss 56b ist mit dem Halbleitersubstrat 41 verbunden. Halbleitereigenschaften des Halbleitersubstrats 41 führen zu einem, gegebenenfalls temperaturabhängigen, ohmschen Widerstand 58, der zwischen dem Anschluss 56b und der Dielektrikumsstruktur 42 wirksam ist. Der Kondensator 40 kann somit als Bedämpfungselement, wie etwa ein Tiefpass bzw. ein sogenannter "RC-Snubber" eingesetzt werden. Der Kondensator 40 kann auch als integrierter Grabenkondensator bezeichnet werden, wenn der (äquivalente) Serienwiderstand (Equivalent Serial Resistance - ESR) hinreichend klein ist. Dies kann z.B. durch den Einsatz eines hochdotierten Halbleitersubstrates bewirkt werden.

Die erste Dielektrikumsschicht 44 weist einen ersten Temperaturausdehnungskoeffizienten $\alpha_1$ und eine erste Dielektrizitätszahl $\varepsilon_1$ auf. Der erste Temperaturkoeffizient $\alpha_1$ führt zu einer thermisch induzierten Materialspannung $\Delta_1$. Die zweite Dielektrikumsschicht weist einen zweiten thermischen Ausdehnungskoeffizienten $\alpha_2$ und eine zweite Dielektrizitätszahl $\varepsilon_2$ auf. Der erste Temperaturkoeffizient $\alpha_2$ führt zu einer thermisch induzierten Materialspannung $\Delta_2$. Der thermische Ausdehnungskoeffizient $\alpha_1$ und/oder $\alpha_2$ kann von einem thermischen Ausdehnungskoeffizienten $\alpha_0$ des Halbleitersubstrats 41, der zu einer thermisch induzierten Materialspannung $\Delta_0$ führt, verschieden sein. Vereinfacht ausgedrückt sind die erste Dielektrikumsschicht 44 und die zweite Dielektrikumsschicht 46 aus voneinander verschiedenen dielektrischen Materialien gebildet. Ein Verhältnis der Dielektrizitätszahlen $\varepsilon_1$ und $\varepsilon_2$ kann basierend auf einem Dickenverhältnis der Dielektrikumsschichten 44 und 46 zum Erhalt einer insgesamt wirksamen Dielektrizitätszahl gewählt werden. Die Wahl der Dielektrizitätszahl bzw. deren Einstellung kann zur Einstellung einer wirksamen Kapazität des Kondensators 40 genutzt werden. Alternativ oder zusätzlich kann eine Vorauswahl der verwendeten Materialien basierend auf einer zu erhaltenden Gesamt-Durchbruchfeldstärke erfolgen. Anschließend kann eine Materialauswahl und/oder eine Wahl der Dickenverhältnisse erfolgen.

Das Halbleitersubstrat 41 sowie die Dielektrikumsschichten 44 und 46 umfassen jeweils eine Gesamt(material)spannung. Diese umfasst eine intrinsische Materialspannung und eine thermisch induzierte Verformung (Materialspannung), etwa bei einem Abkühlen der Struktur nach dem Abscheiden einer Schicht. Von einander verschiedene thermische Ausdehnungskoeffizienten des Halbleitersubstrats $\alpha_0$ und/oder der $\alpha_1$ und

$\alpha_2$ der Dielektrikumsschichten 44 und 46 können zu induzierten Verspannungen führen. Ferner umfassen das Halbleitersubstrat und die Dielektrikumsschichten 44 und 46 jeweils die intrinsische Materialspannung $\sigma_0$, $\sigma_1$ bzw. $\sigma_2$, die zumindest teilweise durch Fremdatome (etwa ein Dotierstoff) in einem Kristallgitter (etwa das Halbleitermaterial) oder durch Fehlanpassungen einzelner Moleküle zueinander verursacht sind.

Alternativ, etwa wenn ein Anteil der intrinsischen Spannung oder der thermisch induzierten Materialspannung an der Gesamtspannung gering ist, bspw. weniger als 30 %, weniger als 20 % oder weniger als 10 %, kann die Kompensation der Materialspannungen auch basierend auf den thermisch induzierten Materialspannungen bzw. den intrinsischen Materialspannungen erfolgen.

Die Gesamtmaterialspannung wirkt dabei entlang einer lateralen Richtung 43, etwa eine Längen- oder Breitenrichtung bzw. einer radialen Richtung, die senkrecht zu einer Richtung der Dicken $d_1$ und $d_2$ bezüglich des Halbleitersubstrats 41 angeordnet ist und kann eine konvexe oder konkave Verformung des Halbleitersubstrats 41 bewirken. Eine laterale Richtung 43' ist im Wesentlichen parallel zu einer Oberfläche des Halbleitersubstrats und bspw. außerhalb des Grabens 52 parallel zu der lateralen Richtung 43 und innerhalb des Grabens 52 hiervon verschieden, wie etwa stellenweise senkrecht hierzu. Entlang der lateralen Richtung 43' kann die Dielektrikumsstrukutr 42 bzw. die erste Dielektrikumsschicht 44 und/oder die zweite Dielektrikumsschicht 46 eine Richtungsänderung (Inversion) einer Ausrichtung der Gesamtmaterialspannung (positiv/negativ) bezogen auf das Halbleitersubstrat 41 aufweisen. Die Inversion kann sich dabei auf einen ersten Bereich des Halbleitersubstrats 41, der den Graben 52 aufweist, und einen zweiten Bereich des Halbleitersubstarts 41, der den Graben 52 nicht aufweist, beziehen. Weist die erste Dielektrikumsschicht 44 bspw. in einem Bereich außerhalb des Grabens 52 eine Schubspannung gegenüber dem Halbleitersubstrat 41 auf, so kann die Dielektrikumsschicht 44 in dem Bereich des Grabens 52 eine Zugspannung bezogen auf das Halbleitersubstrat 41 aufweisen bzw. in das Halbleitersubstrat 41 induzieren und andersherum. Die Inversion kann durch Materialveränderungen hervorgerufen werden, etwa durch einen "Silizumverbrauch" (oxidiertes Silizium) bei einer Oxidation des Siliziums zur Erzeugung oder Abscheidung einer Siliziumoxidschicht 44 an dem Halbleitersubstrat 41. Für die Oxidation kann das Halbleitersubstrat 41 an einer Oberflächenkante (Rand) des Grabens 52 "weniger" Silizium zur Verfügung stellen, als an einer inneren Krümmung (Tal) des Grabens 52, weswegen sich hier die Richtungen, entlang derer die Gesamtspannungen bezüglich des Halbleitersubstrats 41 wirken, umkehren können. Die von einander verschiedenen Gesamtspannungen können alternativ oder zusätzlich eine Verformung in dem Graben induzieren, so dass die laterale Richtung 43 in dem Graben 52 mit einer Dickenrichtung des Halbleitersubstrats 41 stellenweise übereinstimmt. Eine Tiefe 45 der Grabenstruktur 52 kann um ein Vielfaches größer sein, als eine Breite 53 der Grabenstruktur 52.

Die Inversion der Gesamtspannungen ermöglicht eine Auslegung der Schichtdicken der Dielektrikumsstruktur 42 und des Grabens 52 in wechselseitiger Gegenüberstellung und/oder Abhängigkeit. So kann ein Ziel der Auslegung darin liegen, den oder die Gräben mit einer möglichst großen Tiefe 45 zu realisieren, so dass eine außerhalb des oder der Gräben 52 bezüglich des Halbleitersubstrats 41 induzierte Gesamtspannung der Dielektrikumsstruktur 42 bezogen auf eine in dem oder den Gräben 52 induzierte Gesamtspannung vernachlässigbar ist. Eine oder mehrere Schichtdicken $d_1$ und/oder $d_2$ oder Schichtmaterialien zum Erhalt einer angestrebten (Dauer-)Betriebs- oder Durchbruchsspannung des Kondensators kann zu einer veränderten Grabentiefe 45 führen und andersherum.

Die Dielektrikumsschicht 44 weist eine Dicke $d_1$ auf. Die Dielektrikumsschicht 46 weist eine Dicke $d_2$ auf. Umfasst die erste Dielektrikumsschicht 44 beispielsweise Siliziumoxid, so kann die Dicke $d_1$ einen Wert von zumindest oder mehr als 250 nm, mehr als 300 nm oder mehr als 330 nm aufweisen. Die Dicke $d_2$ kann beispielsweise einen Wert von zumindest 400 nm, zumindest 600 nm oder zumindest 1000 nm aufweisen. Alternativ kann die Dicke $d_2$ auch in einem Verhältnis zu der Dicke $d_1$ gewählt werden. Beispielsweise kann die Dicke $d_2$ mit einer doppelten, dreifachen, vierfachen oder anderen Dicke bezogen auf die Dicke $d_1$ gewählt werden. Dies ermöglicht beispielsweise eine Reduzierung oder Kompensation mechanischer Spannungen bei zunehmender Schichtdicke $d_1$, die auch zu eine zunehmenden Schichtdicke $d_2$ führen kann.

Eine maximale Schichtdicke der Dielektrikumsstruktur 42 kann durch eine Schichtdicke einer Dielektrikumsschicht ohne erfolgte Kompensation der Materialspannungen und/oder durch eine Topografie (bspw. eine Breite 53) der Grabenstruktur 52 begrenzt sein. Eine zunehmende Schichtdicke kann zu einer Reduzierung der Oberfläche der Dielektrikumsstruktur durch zunehmendes "Auffüllen" des Grabens führen. Dadurch wird auch eine Fläche reduziert, die von dem Elektrodenmaterial 48 bedeckt wird. Dies führt zu einer wiederum reduzierten Oberflächenvergrößerung und einer geringeren Kapazität des Kondensators 40. In einem zu vermeidenden Extremfall weist die Dielektrikumsstruktur 42 beispielsweise eine Gesamtdicke auf, die einer halben "Breite" der Grabenstruktur 52 entspricht. Die Grabenstruktur 52 ist dann durch die Dielektrikumsstruktur entlang einer Richtung der Breite 53 verschlossen. Das Elektrodenmaterial würde vereinfacht ausgedrückt als ebene Schicht angeordnet, was zu einer Kapazität führt, die kleiner ist, als bei einer vollständig planaren Anordnung der Schichten. Der Begriff "Breite" bezieht sich hier auf eine laterale Ausdehnung der Grabenstruktur 52 senkrecht zu einer Dickenrichtung und kann je nach Ausführung der Grabenstruktur 52 auch auf eine Länge, d.h. eine andere Richtung, und/oder einen Durchmesser der Grabenstruktur 52 bezogen sein.

Eine Gesamtdicke der Dielektrikumsstruktur 42, d.h. des Schichtstapels, kann beispielsweise ≥ 800 nm, ≥ 1000 nm, ≥ 1200 nm oder mehr betragen. Ein Schichtdickenverhältnis zwischen einer Oxidschicht und einer Nitrid-Schicht, wenn die Dielektrikumsstruktur 42 diese Schichten umfasst, kann beispielsweise in einem Verhältnis von 0,2 bis 1 liegen, das bedeutet, die Dielektrikumsschicht (Nitrid) 46 weist eine Dicke von 100% bis 500% der Dielektrikumsschicht 44 (Oxid) auf.

Gemäß einem Ausfürungsbeispiel eine erste Schichtdicke, etwa der Siliziumnitridschicht, geringer oder gleich sein, als die zweite Schichtdicke, etwa der Siliziumoxidschicht. Das bedeutet, dass die erste Dielektrikumsschicht und die zweite Dielektrikumsschicht so gebildet werden, dass die erste Schichtdicke zumindest ein 0,4-faches und höchstens ein 1-faches der zweiten Schichtdicke beträgt. Alternativ kann die erste Schichtdicke zumindest ein 0,5-faches und höchstens ein 1-faches oder zumindest ein 0,6-faches und höchstens ein 0,99-faches der zweiten Schichtdicke aufweisen.

Gemäß Ausfürungsbeispielen kann die erste Schichtdicke unabhängig von den Materialien auch größer sein, als die die zweite Schichtdicke. Das bedeutet, dass die erste Dielektrikumsschicht und die zweite Dielektrikumsschicht so gebildet werden, dass die erste Schichtdicke zumindest ein 0,4-faches und höchstens ein 1,5-faches der zweiten Schichtdicke beträgt. Alternativ kann die erste Schichtdicke zumindest ein 0,5-faches und höchstens ein 1,3-faches oder zumindest ein 0,6-faches und höchstens ein 1,1-faches der zweiten Schichtdicke aufweisen. Ein Verhältnis der Schichtdicken zueinander kann basierend auf den erhalten Materialspannungen gewählt werden, um eine Durchbiegung des Substrats innerhalb prozessierbarer Grenzen zu halten.

Eine Oxidschicht kann beispielsweise auf einem Siliziumsubstrat einen negativen thermischen Stress und einen positiven intrinsischen Stress aufweisen oder induzieren, der Größenordnungen von 100 MPa, 200 MPa oder 300 MPa entlang einer jeweiligen positiven oder negativen Richtung aufweisen kann. Siliziumnitrid kann beispielsweise auf einem Siliziumsubstrat einen positiven thermischen Stress und einen positiven intrinsischen Stress aufweisen, das bedeutet, beide Stressarten sind gleichgerichtet. Positiver Stress bezeichnet dabei eine mechanische Zugspannung durch die aufgebrachte Schicht, welche beim Aufbringen auf der Oberseite eines Substrates zu einer konvexen Verbiegung führt. Negativer Stress bezeichnet entsprechend eine mechanische Druckspannung durch die aufgebrachte Schicht, welche beim Aufbringen auf der Oberseite eines Substrates zu einer konkaven Verbiegung führt.

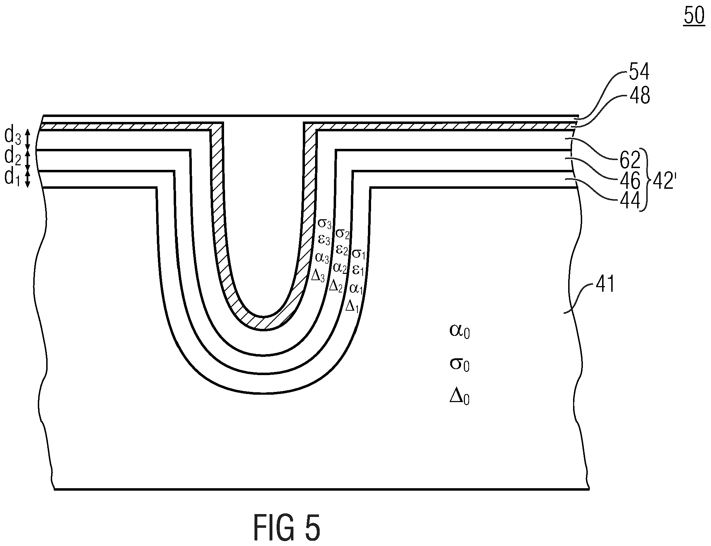

Fig. 5 zeigt eine schematische Seitenschnittansicht eines Kondensators 50, bei dem, verglichen mit dem Kondensator 40, eine Dielektrikumsstruktur 42' eine dritte Dielektrikumsschicht 62 umfasst. Die dritte Dielektrikumsschicht 62 weist einen Temperaturkoeffizienten $\alpha_3$, eine intrinsische Materialspannung $\sigma_3$ und eine Dielektrizitätszahl $\varepsilon_3$ auf, die vom Temperaturkoeffizienten $\alpha_1$ und/oder $\alpha_2$, den intrinsischen Materialspannungen $\sigma_1$ und/oder $\sigma_2$ bzw. den Dielektrizitätszahlen $\varepsilon_1$ und/oder $\varepsilon_2$ verschieden sind. Der thermische Ausdehnungskoeffizient $\alpha_3$ führt zu einer thermisch induzierten Materialspannung $\Delta_3$. Eine Dicke $d_3$ der dritten Dielektrikumsschicht 62 kann basierend auf intrinsischen Materialspannungen der Schichten 44, 46 und 62 und/oder basierend auf dem thermischen Ausdehnungsverhalten bzw. der Gesamtspannung der jeweils anderen Schichten sowie des Substrats 41 gewählt werden. Durch Anordnen einer Nitridschicht an eine Oxidschicht kann ein sogenannter "ON-(Oxid-Nitrid)-Stapel" erhalten werden. Eine Anordnung einer weiteren Oxidschicht an der Nitridschicht kann den Erhalt eines sogenannten ONO-(Oxid-Nitrid-Oxid)-Stapels ermöglichen.

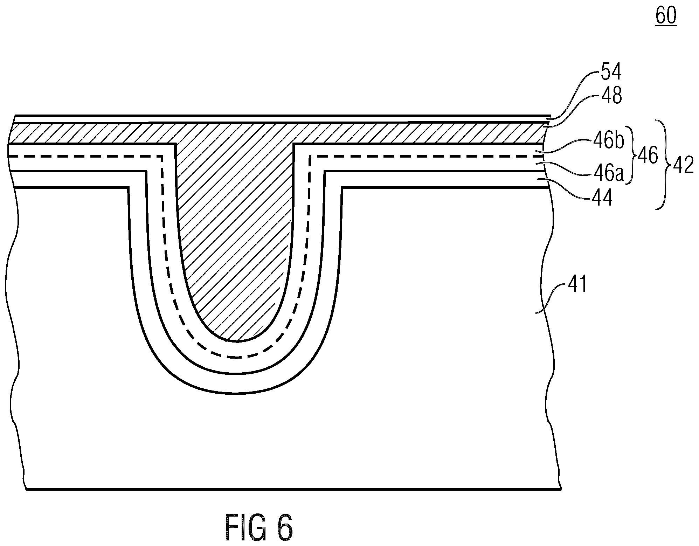

Fig. 6 zeigt einen Ausschnitt einer schematischen Seitenschnittansicht eines Kondensators 60, bei dem die zweite Dielektrikumsschicht 46 der Dielektrikumsstruktur 42 mittels zweier Teilschichten 46a und 46b gebildet ist. Die Teilschicht 46a kann mittels des Schritts 220 erhalten werden. Die zweite Teilschicht 46b kann mittels einer Ausführung des Schrittes 240 erhalten werden. Das Elektrodenmaterial "verfüllt" ein von den Dielektrikumsschichten 44 und 46 nicht verfülltes Volumen der Grabenstruktur 52 vollständig.

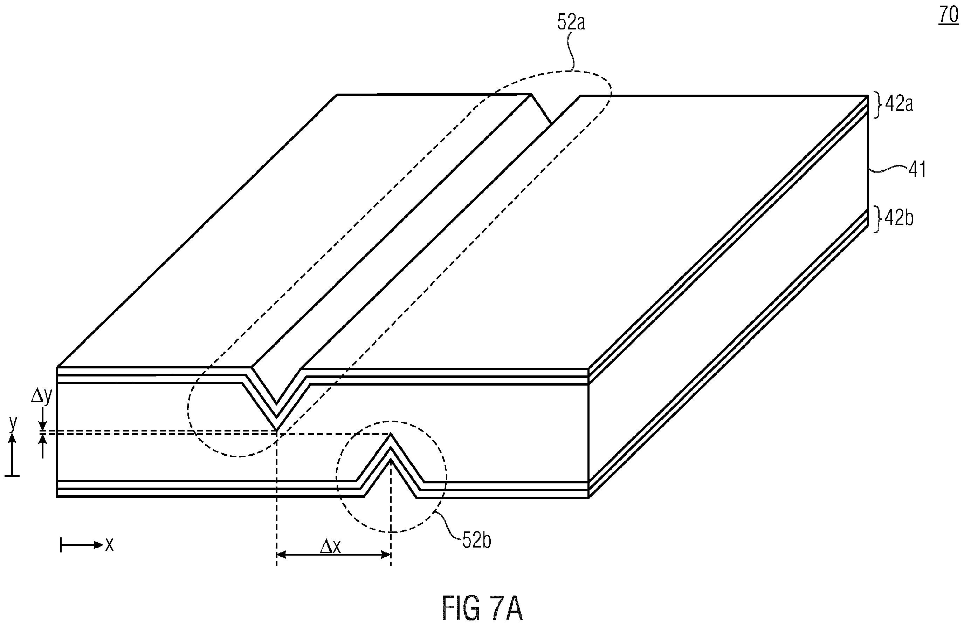

Fig. 7a zeigt eine schematische Seitenschnittansicht eines Zwischenprodukts eines Verfahrens zur Herstellung eines Kondensators 70, bei dem an einer ersten Hauptseitenoberfläche des Halbleitersubstrats 41 eine Dielektrikumsstruktur 42a und an einer zweiten Hauptseitenoberfläche eine Dielektrikumsstruktur 42b gebildet ist. Die Dielektrikumsstrukturen 42a und 42b umfassen, von dem Halbleitersubstrat 41 ausgehend die gleichen Dielektrikumsschichten. Dies kann mittels einer gleichzeitigen Prozessierung der beiden Hauptseiten (beispielsweise Oberseite und Unterseite) des Halbleitersubstrats 41 erfolgen, etwa in einem Ofen, in dem beide Seiten gleichzeitig oxidiert werden oder eine Abscheidung erfolgt.

In eine Oberseite des Halbleitersubstrats 41 ist eine Grabenstruktur 52a integriert. In eine Unterseite des Halbleitersubstrats 41 ist eine Grabenstruktur 52b integriert. Die Grabenstrukturen 52a und 52b sind entlang einer lateralen Richtung x des Halbleitersubstrats 41 mit einem Abstand $\Delta x$ zueinander angeordnet. Der Abstand $\Delta x$ kann einen beliebigen Wert von ≥ null aufweisen. Beträgt der Abstand $\Delta x$ beispielsweise null, d.h. sind die Grabenstrukturen 52a und 52b einander gegenüberliegend angeordnet, so kann eine Verformung des Halbleitersubstrats 41, die durch die Materialaussparungen des Halbleitersubstrats 41 in den Grabenstrukturen 52a und 52b induziert wird, basierend auf einer symmetrischen und einander entgegengesetzten Verformung zumindest teilweise kompensiert werden. Ein lateraler Abstand $\Delta x$

von mehr als null kann ebenfalls eine zumindest teilweisen Kompensation dieser Verformungseffekte ermöglichen und ermöglicht ferner, dass eine minimale Dicke $\Delta y$ des Halbleitersubstrats 41 verglichen mit einer Situation, bei der der Abstand $\Delta x$ null beträgt (verbleibende Dicke des Halbleitersubstrats zwischen den Grabenstrukturen 52a und 52b wird minimal) und die Vertiefungen der Grabenstrukturen 52a und 52b gegenüberliegend angeordnet sind, vergrößert ist. Ein Abstand $\Delta x$ von ungleich 0 ermöglicht eine erhöhte Bruchfestigkeit und eine verbesserte Wärmeableitung des Kondensators, da eine Dicke des Halbleitersubstrats 41 verglichen mit einem Abstand $\Delta x = 0$ erhöht ist.

Vereinfacht ausgedrückt weist der Kondensator 70 Grabenstrukturen 52a und 52b an beiden Hauptoberflächen auf. Alternativ kann die Dielektrikumsstruktur 42b auch andere Schichten aufweisen als die Dielektrikumsstruktur 42a und/oder Schichtdicken der Dielektrikumsschichten können eine voneinander verschiedene Schichtdicke aufweisen. Obwohl die Grabenstrukturen 52a und 52b gleich dargestellt sind, kann eine Anzahl, Tiefe oder Art der Gräben voneinander verschieden sein.

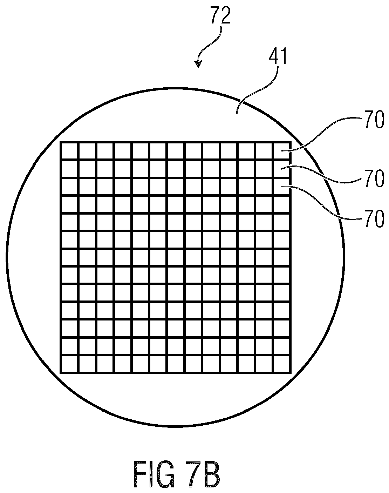

Fig. 7b zeigt eine schematische Aufsicht auf einen Wafer 72 vor einer Trennung der einzelnen Komponenten bzw. vor einem Dicing. Der Wafer 72 weist das Halbleitersubstrat 41 und eine Vielzahl von Kondensatoren 70 auf. Die Kondensatoren 70 bilden auf dem Wafer 72 jeweils einen Kondensatorbereich. Die in Fig. 7a dargestellten Dielektrikumsschichten sind über die Vielzahl von Kondensatoren 70 (gemeinsam) und ggf. über Zwischenräume zwischen den Kondensatorbereichen hinweg gebildet. Eine Durchbiegung des Wafers 72 während der Ausbildung der Kondensatoren 70 ist basierend auf den entgegengesetzten Materialspannungen reduziert.

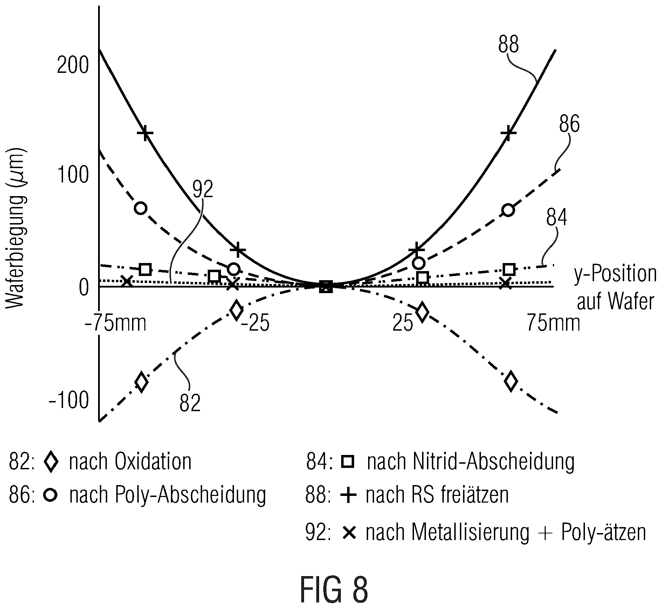

Fig. 8 zeigt beispielhaft einen möglichen Verlauf einer Durchbiegung eines Wafers (Halbleitersubstrat) während einer Herstellung von Kondensatoren, wie sie beispielsweise durch das Verfahren 100 erhalten werden kann.

An einer Abszisse des Graphen ist ein radialer Abstand von einem Mittelpunkt des Wafers angetragen. Der Wafer weist beispielsweise einen Durchmesser von 150 mm auf, so dass der radiale Abstand einen Wert zwischen -75 mm und +75 mm aufweist. An einer Ordinate des Graphen ist eine Waferdurchbiegung angetragen.

Ein erster Kurvenverlauf 82 zeigt eine Durchbiegung des Wafers nach einer Anordnung einer ersten Dielektrikumsschicht an dem Halbleitersubstrat ("nach Oxidation"), etwa mittels des Schrittes 210 oder 310. Die Anordnung kann beispielsweise durch eine Oxidation, alternativ auch durch eine Abscheidung der Schicht erfolgen. Eine Grabenstruktur kann beispielsweise mittels 20 $\mu$m tiefen Löchern, die in einem hexagonalen Raster angeordnet sind, realisiert sein. Die Löcher können beispielsweise einen Durchmesser von 5,5 $\mu$m und einen Abstand von 7 $\mu$m zwischen den Lochmittelpunkten aufweisen, wobei auch andere Durchmesser und/oder Abstände bzw. eine andere Ausgestaltung der Grabenstruktur möglich sind. Die Anordnung der ersten Dielektrikumsschicht, führt beispielhaft zu einer als konkav (alternativ konvex) bezeichneten Verbiegung des Wafers (Halbleiterscheibe) mit einer Höhe von in etwa 100 $\mu$m, wobei sich die Höhe auf eine maximale Durchbiegung von dem Mittelpunkt ausgehend bezieht.

Ein Kurvenverlauf 84 zeigt eine Durchbiegung nach einer erfolgten Anordnung einer zweiten Dielektrikumsschicht an der ersten Dielektrikumsschicht ("nach Nitrid-Abscheidung"). Beispielsweise umfasst die zweite Dielektrikumsschicht Siliziumnitrid. Mechanische Spannungen der zweiten Dielektrikumsschicht wirken mechanischen Spannungen der ersten Dielektrikumsschicht entgegen, so dass die konkave Verformung zu einer konvexen Verformung in einem Umfang von in etwa 20 $\mu$m reduziert ist. Die erste Dielektrikumsschicht weist beispielsweise eine Dicke von 330 nm auf. Eine Dicke der zweiten Dielektrikumsschicht beträgt beispielsweise 500 nm. Dies kann dazu führen, dass sich die mechanischen Spannungen der Schichten nahezu vollständig kompensieren und die Halbleiterscheibe nur noch eine sehr geringe Verbiegung aufweist.

Ein Kurvenverlauf 86 zeigt die Verbiegung des Wafers nach einer Abscheidung des Elektrodenmaterials ("nach Poly-Abscheidung"), beispielsweise mittels des Schrittes 130, etwa durch Anordnung von Polysilizium. Die Abscheidung kann beispielsweise in einem Temperaturbereich zwischen 500 °C und 600 °C, zwischen 550 °C und 590 °C oder bei in etwa 570 °C erfolgen und führt zu einer zusätzlichen konvexen Verbiegung.

Ein Kurvenverlauf 88 zeigt die Durchbiegung des Wafers nach einer erfolgten Entfernung der dielektrischen Materialien der Dielektrikumsstruktur von der Rückseite (RS) des Halbleitersubstrats ("nach RS freiätzen"). Das Entfernern der Materialien führt zu einer reduzierten Kompensation der Materialspannungen, die die Dielektrikumsstruktur bezogen auf eine mittlere Dicke des Halbleitersubstrats ermöglicht. Die entfernten, aufgehobenen induzierten Materialspannungen an der Vorder- und der Rückseite ermöglicht wird auf induzierte Materialspannungen an der Vorderseite reduziert. Das bedeutet, dass eine Auslenkung des Wafers (Durchbiegung) steigt. In anderen Worten führt die Abscheidung des Elektrodenmaterials (86) aus in-situ-dotiertem Polysilizium zu einer zusätzlichen konvexen Verbiegung, welche durch das Entfernen des Schichtstapels von der Scheibenrückseite (88) noch verstärkt wird. Die Verbiegung der Halbleiterscheibe kann nach diesem Schritt maximal sein und im obigen Beispiel beispielsweise 210 $\mu$m betragen.

Ein Kurvenverlauf 92 zeigt eine Durchbiegung des Wafers nach einer Metallisierung der Dielektrikumsstruktur, beispielsweise mittels des Schrittes 140 und nach einer Strukturierung des Polysiliziummaterials("nach Metallisierung und Poly-ätzen"), etwa zur elektrischen Trennung der einzelnen Kondensatoren voneinander in Vorbereitung auf eine elektrische Messung auf Waferebene (Waferprober) und/oder zur Vorbereitung der mechanischen Trennung in dem Schritt 160 oder als Teil davon. Eine Unterbrechung der Polysiliziumschicht führt zu einer partiellen Unterbrechung der Materialspannung dieser Schicht. Der Kurvenverlauf 92 zeigt eine Durchbiegung von in etwa 0 $\mu$m. In anderen Worten kann nach der den vorangehenden Schritten anschließenden Metallisierung der Kondensatorflächen auf der Scheibenvorderseite die Polysiliziumschicht zwischen den Bauelementen entfernt, beispielsweise zurückgeätzt werden, wodurch diese Schicht unterbrochen wird und sich die Verbiegung wieder auf das vorherige, d.h. ein ursprüngliches, Niveau reduziert.

Der Schritt 140 und der Schritt 150 des Verfahrens 100 können somit in beliebiger Reihenfolge ausgeführt werden. Entweder kann zuerst eine Metallisierung bzw. das Bilden eines elektrischen Anschlusses erfolgen und anschließend Material von der Rückseite des Wafers entfernt werden oder es kann zuerst das Material entfernt werden und anschließend der metallische Kontakt gebildet werden. Alternativ kann das Entfernen des Materials von der Scheibenrückseite auch entfallen.

Eine Nennspannung der erzeugten Bauelemente auf der Halbleiterscheibe kann größer sein als 300 Volt, beispielsweise in etwa 400 Volt. Eine Integrationsdichte der Bauteile kann beispielsweise 0,5 nF/mm$^2$ betragen, was einer Oberflächenvergrößerung von 8,8 entsprechen kann. Die Oberflächenvergrößerung bezieht sich hierbei auf einen Kapazitätswert, der ohne eine Anordnung der Grabenstrukturen bei identischer Schichtdicke der Dielektrikumsschichten erreicht werden würde.

Durch die Verringerung einer maximalen Durchbiegung des Wafers während des Herstellungsverfahrens ist die Verwendung von Wafern mit größeren Durchmessern (etwa 200 mm, 300 mm oder mehr anstelle von 150 mm) möglich, da eine (ggf. quadratisch) mit dem Durchmesser zunehmende Verbiegung auch für vergrößerte Wafer-Durchmesser unterhalb kritischer Werte gehalten werden kann.

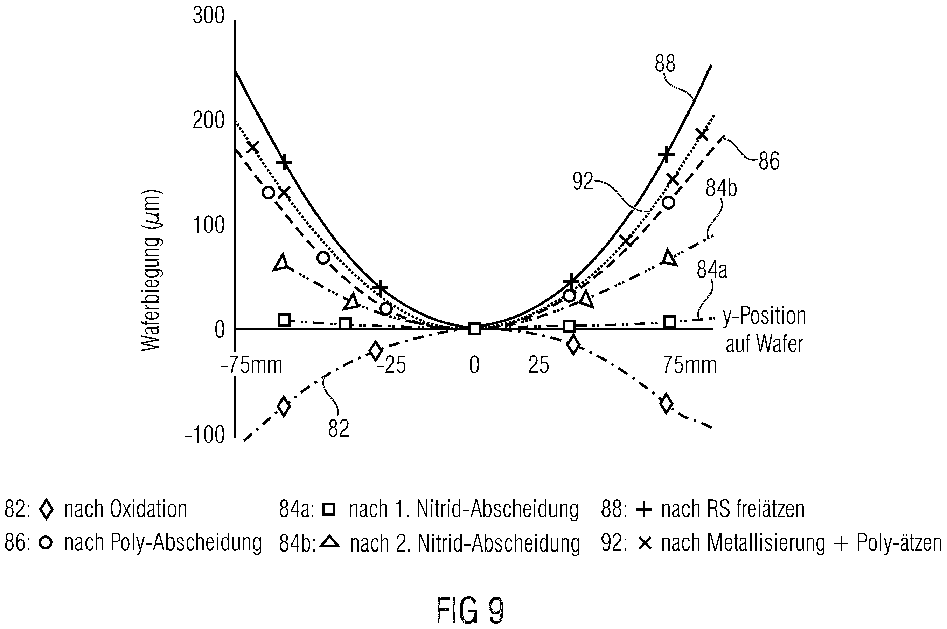

Fig. 9 zeigt eine schematische Darstellung verschiedener Durchbiegungen des Wafers, bei denen im Vergleich zu den Darstellungen in der Fig. 8 die zweite Dielektrikumsschicht in etwa doppelt so dick ausgeführt ist und mittels zweier Teilschritte, wie es für das Verfahren 200 beschrieben ist, gebildet ist. In dem ersten Teilschritt werden beispielsweise ca. 500 nm Siliziumnitrid und in dem zweiten Teilschritt beispielsweise ca. 580 nm Siliziumnitrid abgeschieden. Die Abscheidung der ersten Teilschicht ist in einem Kurvenverlauf 84a ("nach 1. Nitrid-Abscheidung") dargestellt, der im Wesentlichen dem Kurvenverlauf 84 in Fig. 8 entspricht. Die erhöhte Schichtdicke der zweiten Dielektrikumsschicht, d.h. der zweiten Siliziumnitridschicht, führt zu einer weiteren konvexen Verbiegung der Scheibe, wie durch einen Kurvenverlauf 84b ("nach 2. Nitrid-Abscheidung") angedeutet, so dass diese während des Gesamtprozesses einen Maximalwert von in etwa 250 $\mu$m aufweist. Die erhöhte

Schichtdicke führt zu einer jeweils stärkeren Durchbiegung in den Kurvenverläufen 86, 88 und 92, was zumindest teilweise durch eine Überkompensation der Materialspannungen der ersten Dielektrikumsschicht induziert ist.

Die maximale Verbiegung reduziert sich nach der Strukturierung der Polysiliziumschicht (Kurvenverlauf 92) auf in etwa 200 $\mu$m.

Eine Gesamtdicke des Dielektrikums kann so beispielsweise in etwa 1400 nm (333 nm Siliziumoxid und 1080 nm Siliziumnitrid) betragen. Ein Dickenverhältnis der Oxidschicht und der Nitridschicht weist somit einen Wert von in etwa 1:3 auf.

Dies kann zu einer zuverlässige Nennspannung des Kondensators von 600 Volt oder mehr führen. Eine dickere Ausführung der ersten Dielektrikumsschicht und/oder der zweiten Dielektrikumsschicht und/oder eine Anordnung einer weiteren Dielektrikumsschicht ermöglicht eine dickere oder dünnere physikalische Gesamtdicke unter Beibehaltung der maximalen Waferdurchbiegung, so dass auch höhere Nennspannungen von 650 Volt, 700 Volt oder mehr erreichbar sind. Mit dem Verfahren 100 hergestellte Kondensatoren bzw. RC-Glieder können eine Kapazität von beispielsweise 0,2 nF/mm$^2$, 0,3 nF/mm$^2$, 0,4 nF/mm$^2$ oder mehr und eine Oberflächenvergrößerung von beispielsweise $\geq 5$, $\geq 6$, $\geq 7$ (beispielsweise 7,4) oder mehr bei einer gleichzeitigen hohen Spannungsfestigkeit von z. T. deutlich über 45 V aufweisen, etwa zumindest 48 V, zumindest 100 V oder zumindest 300 V. Eine erzielbare Oberflächenvergrößerung basiert auf der Spannungsfestigkeit der Dielektrikumsstruktur, d. h., auf einer Dicke des Dielektrikums.

Ein Auslegungskriterium von Grabenstrukturen und dielektrischen Schichten kann beispielsweise eine anfängliche Bestimmung einer größtmöglichen Verbiegung der Halbleiterscheibe umfassen, bei der eine gegebenenfalls größtmögliche Flächenvergrößerung ausgeführt wird, wobei eine maximale Verbiegung durch die dielektrischen Schichten beeinflusst ist.

Fig. 10 zeigt eine schematische perspektivische Ansicht einer Verbiegung eines Silizium-Wafers mit einem Durchmesser von 150 mm gemäß dem Stand der Technik. Der Silizium-Wafer ist so ausgeführt, dass er Grabenstrukturen mit einer 10-fachen Oberflächenvergrößerung aufweist. Der Wafer weist ferner eine Dielektrikumsstruktur aus einer ersten 20 nm dicken Siliziumoxidschicht und einer zweiten 1050 nm dicken Siliziumnitridschicht auf, was einer effektiven Schichtdicke $D_{CET}$ von etwa 566 nm entspricht. Dies führt zu einer theoretischen Betriebsspannung von etwa 400 Volt. Eine maximale Durchbiegung eines derartigen Wafers beträgt in etwa 770 $\mu$m entlang der Dickenrichtung y aus einer x-/z-Ebene, in welcher der Wafer angeordnet ist, heraus. Im Vergleich zu diesen Durchbiegungen zeigen die Figuren 8 und 9 eine deutlich geringere Verbiegung der Halbleiterscheibe von 770 $\mu$m auf 300 bzw. 250 $\mu$m. Dies ermöglicht eine anschließende Oberflächenpassivierung mittels Polyimid, inklusive eines Lithographieschrittes, um diese zu strukturieren.

In anderen Worten ermöglicht eine Abstimmung von zumindest zwei Dielektrikumsschichten aufeinander, dass die Scheibenverbiegung zu allen relevanten Punkten des Herstellungsprozesses eine maximal zulässige Verbiegung nicht überschreitet. Dies kann insbesondere bedeuten, dass nach der Fertigstellung der Kondensatoren bzw. einer erfolgten Ausbildung derselben in einem Wafer, eine Verbiegung der Halbleiterscheibe geringer als 300 μm oder 250 μm ist, wie es in den Figuren 8 und 9 dargestellt ist. Die maximal zulässige Verbiegung kann abhängig von eingesetzten Halbleiterfertigungsgeräten bestimmbar sein und kann für eine kommerzielle Anwendung des Herstellungsverfahrens beispielsweise im Bereich von in etwa 250 μm bis 500 μm liegen. Aus dem Bereich von Halbleiter-Foundries (Zwischenprodukthersteller) sind teilweise auch Werte von max. 150 μm bekannt, so dass eine maximale Verbiegung unterhalb dieses Wertes verbleiben soll. Oben aufgeführte Ausführungsbeispiele erhalten somit auch in diesem Bereich Relevanz.

Alternativ zu den oben beschriebenen Verfahren der Kondensatoren lassen sich auch andere Materialien und andere Prozessschritte zur Herstellung der Dielektrikumsschichten der Dielektrikumsstruktur einsetzen. Beispielsweise lässt sich eine Siliziumoxidschicht auch durch eine feuchte, d.h. eine nasse oder eine mittels Wasserstoffperoxid-Verbrennung ausgeführte thermische Oxidation ausführen. Alternativ kann eine Siliziumoxidschicht oder andere Schichten auch mittels einer CVD-Abscheidung, etwa aus Tetraethylorthosilicat (TEOS) und/oder als Hochtemperaturoxidation/Niedrigtemperaturoxidation (High Temperature Oxide - HTO/Low Temperature Oxide - LTO) angeordnet werden. Als dielektrische Schichten können diverse Materialien, insbesondere auch sogenannte "high-K-Dielektrika", d.h. Dielektrika mit hoher Dielektrizitätskonstante eingesetzt werden. Dazu gehören beispielsweise Titanoxid, Tantaloxid, Hafniumoxid, Alumiumoxid oder Lantanoxid und weitere Mischoxide wie Hafniumaluminiumoxid.

Um die maximale Scheibenverbiegung während des Herstellungsprozesses möglichst gering zu halten, kann es außerdem vorteilhaft sein, zunächst das Elektrodenmaterial auf der Vorderseite zu strukturieren, bevor der gesamte Schichtstapel von der Rückseite entfernt wird. So kann beispielsweise eine Spannung, die durch einen Schichtstapel an der Rückseite kompensiert wird, zuerst reduziert werden, bevor mittels der Entfernung die kompensierenden Effekte reduziert werden.

Durch die Verringerung der mechanischen Verbiegung kann schlussendlich eine höhere Integrationsdichte erreicht werden, da sich durch engere Anordnung der 3D-Strukturen, d.h. der Grabenstrukturen, eine höhere Oberflächenvergrößerung erzielen lässt. Die Verwendung eines mehrschichtigen Dielektrikums, bei dem sich die mechanischen Spannungen der einzelnen Schichten in ausreichendem Maße, d.h. so dass die Waferdurchbiegung unterhalb einer Obergrenze verbleibt, gegenseitig kompensieren, ermöglicht es, monolithisch integrierte Kondensatoren oder RC-Glieder für hohe Nennspannungen (z.B. 600 Volt und mehr) mit einer hohen Oberflächenvergrößerung herzustellen. Eine starke Verbiegung der Halbleiterscheibe aufgrund der dicken dielektrischen Schichten kann durch diese Methode reduziert oder vermieden werden, ohne dass zusätzliche Kompensationsstrukturen oder Schichten notwendig sind, welche die erreichbare Integrationsdichte reduzieren und den Herstellungsaufwand erhöhen.

Mittels des beschriebenen Konzepts hergestellte monolithisch integrierte Kondensatoren oder RC-Glieder können in Schaltungen oder in Leistungsmodulen als Puffer- oder Dämpfungskapazitäten eingesetzt werden. Ferner können derartige Bauelemente beispielsweise in Transistoren, etwa vertikal oder doppelt vertikal diffundierte Metall-Oxid-Halbleiter (vertical diffused Metal-Oxide Semiconducotor (VDMOS), Graben-(Trench-)MOS, oder IGBT eingesetzt werden.

Die beschriebenen integrierten Kondensatoren 40, 50 oder 60 bzw. aus dem Zwischenprodukt 70 hergestellte Kondensatoren können beispielsweise zur Absorption von elektrischer Energie aus einem Energiespeicher, beispielsweise zur Implementierung eines Spulen(L)-Kondensator(C)-, eines Widerstands(R)-C-, oder eines LCR-Schwingkreises zur Schaltentlastung, das heißt zur Aufnahme von auftretenden Schaltspitzen in einem Leistungsschalter, zur Spannungsbegrenzung und/oder zur Schwingungsdämpfung in einem elektrischen Netzwerk einsetzbar sein, wenn der entsprechende Kondensator verwendet wird, um das elektrische Netzwerk zu beschalten. Alternativ oder zusätzlich können die integrierten Kondensatoren verwendet werden, um elektrische Energie aus einer Quelle, wie etwa als ein Zwischenkreiskondensator bei einem Spannungswandler zur Spannungsstabilisierung oder zur Spannungsversorgung eingesetzt werden, etwa einem Wechselstrom(Alternating Current - AC)-Gleichstrom(Direct Current - DC), einem AC-AC, einem DC-DC- oder einem DC-AC-Wandler aufzunehmen. In anderen Worten können derartige Leistungsmodule beispielsweise in Wechselrichtern zur Stromeinspeisung, in Antriebsumrichtern zur Antriebssteuerung, in Gleichspannungswandlern zur Stromübertragung oder in Schaltnetzteilen eingesetzt werden.

Alternativ oder zusätzlich ist ebenfalls eine Verwendung eines oder mehrerer der integrierten Kondensatoren als Koppelkondensator oder in einem Leistungsmodul zusammen mit den Leistungsschaltern auf einem Transfersubstrat vorstellbar, in dem der integrierte Kondensator auf dem Transfersubstrat mit den Leistungsschaltern montiert wird. Alternativ oder zusätzlich ist es ebenfalls vorstellbar, einen oder mehrere integrierte Kondensatoren auf einem LEAD-Frame zusammen mit einem oder mehreren Leistungshalbleiterbauelementen zu implementieren und in einem gemeinsamen Gehäuse anzuordnen. In anderen Worten kann der integrierte Kondensator mit einem Leistungsschalter in einem Gehäuse ("Package") angeordnet sein. Alternativ kann zumindest ein integrierter Kondensator mit einem Halbleiterbauelement in einem gemeinsamen Gehäuse oder in einem Gehäuse eines gehäusten Halbleiterbauelementes angeordnet sein. Bei einer Verwendung in einem Leistungsmodul oder in Kombination mit dem Halbleiterbauelement kann der oder die integrierte Kondensatoren bspw. als Koppelkondensator oder als Bedämpfungselement (RC-Snubber) einsetzbar sein.

In anderen Worten kann die Verbiegung der Halbleiterscheibe aufgrund der Herstellung dicker dielektrischer Schichten in monolithisch integrierten Kondensatoren minimiert werden, indem das Dielektrikum derart aus zwei oder mehr gestapelten dielektrischen Schichten aufgebaut wird, das sich die mechanischen Spannungen dieser Schichten teilweise oder vollständig kompensieren. Ein solches mehrschichtiges Dielektrikum kann beispielsweise aus Siliziumoxid und Siliziumnitrid realisiert werden. Dabei erzeugt eine Siliziumoxidschicht entsprechender Dicke eine Druckspannung, welche einer Zugspannung der Siliziumnitridschicht entgegenwirkt. Dabei wird das Dickenverhältnis der beiden Seiten so gewählt, dass sich die erzeugten mechanischen Spannungen und die resultierende Verbiegung der Halbleiterscheibe auf ein zur Weiterverarbeitung hinreichend geringes Maß verringert.

Angestrebte höhere Oberflächenvergrößerungen und/oder Anforderungen zur Erhöhung der Durchschlagsfestigkeit (Erhöhung der Betriebsspannung) führen zu Anforderungen, die ein dickeres Dielektrikum zugrunde legen. Eine größtmögliche oder attraktive Integrationsdichte kann durch Anordnen einer Dielektrikumsstruktur, bei der sich die mechanischen Spannungen der Dielektrikumsschichten zumindest teilweise kompensieren, erreicht werden.

Obwohl manche Ausführungsbeispiele so beschrieben wurden, dass an dem Halbleitersubstrat eine erste Dielektrikumsschicht umfassend Silizium(di)oxid und an der ersten Dielektrikumsschicht eine zweite Dielektrikumsschicht umfassend Siliziumnitrid angeordnet werden, wobei die erste Dielektrikumsschicht eine geringere Schichtdicke aufweist, als die zweite, können die Dielektrikumsschichten auch in einer anderen Anzahl und/oder einer anderen Reihenfolge und/oder so, dass die erste Dielektrikumsschicht eine größere Schichtdicke umfasst, als die zweite Dielektrikumsschicht angeordnet werden.

Im Folgenden werden zusätzliche Ausführungsbeispiele und Aspekte der Erfindung beschrieben, die einzeln oder in Kombination mit beliebigen der hierin beschriebenen Merkmale, Funktionalitäten und Einzelheiten verwendet werden können.

Ausführungsbeispiel 1: Verfahren (100) zum Herstellen eines Kondensators (40; 50; 60; 70) mit folgenden Schritten:

Erzeugen (110) einer Dielektrikumsstruktur (42; 42') in einem Graben (52; 52a; 52b;) eines Halbleitersubstrats (41);

wobei die Dielektrikumsstruktur (42; 42') eine Mehrzahl von aneinandergrenzenden Dielektrikumsschichten (44; 46; 62) aufweist, die einander entgegengesetzte mechanische Gesamtspannungen aufweisen.

Ausführungsbeispiel 2: Verfahren gemäß Ausführungsbeispiel 1, bei dem eine erste Dielektrikumsschicht (44; 46; 62) der Dielektrikumsstruktur (42; 42') eine Schichtdicke aufweist, die größer ist, als 250nm und bei der eine zweite Dielektrikumsschicht (44; 46; 62) eine Schichtdicke aufweist, die größer ist, als 550nm.

Ausführungsbeispiel 2: Verfahren gemäß Ausführungsbeispiel 1, bei dem die erste Dielektrikumsschicht der Dielektrikumsstruktur umfassend Siliziumnitrid gebildet wird und bei dem eine zweite Dielektrikumsschicht der Dielektrikumsstruktur umfassend Siliziumoxid gebildet wird.

Ausführungsbeispiel 3: Verfahren gemäß Ausführungsbeispiel 1 oder 2, bei dem die erste Dielektrikumsschicht und die zweite Dielektrikumsschicht so gebildet werden, dass die erste Schichtdicke zumindest ein 0,4-faches der zweiten Schichtdicke beträgt.

Ausführungsbeispiel 4: Verfahren gemäß einem der vorangehenden Ausführungsbeispiele bei dem das Bilden einer Dielektrikumsschicht (44; 46; 62) der Dielektrikumsstruktur durch Bilden einer ersten Teilschicht (46a) der Dielektrikumsschicht (44; 46; 62) in einem ersten Teilschritt (220) und durch Bilden einer zweiten Teilschicht (46b) der Dielektrikumsschicht (44; 46; 62) in einem zweiten (240) Teilschritt erfolgt, wobei der zweite Teilschritt (240) zu dem ersten Teilschritt (220) einen zeitlichen Abstand (230) aufweist.

Ausführungsbeispiel 5: Verfahren gemäß Ausführungsbeispiel 4, bei dem der erste Teilschritt (220) bei einer Prozesstemperatur ausgeführt wird und bei dem der zeitliche Abstand (230) durch zumindest eines aus einem Verharren bei der Prozesstemperatur für eine Zeitdauer, einem Abkühlen ausgehend von der Prozesstemperatur und einem nachfolgendem Erwärmen und/oder einem Erwärmen ausgehend von der Prozesstemperatur und einem nachfolgendem Abkühlen beeinflusst ist;
wobei während dem Verharren eine geringere Menge von dielektrischem Material oder keine eine Anordnung von dielektrischem Material verglichen mit dem ersten Teilschritt erfolgt.

Ausführungsbeispiel 6: Verfahren gemäß Ausführungsbeispiel 4 oder 5, bei dem die erste Teilschicht (46a) und die zweite Teilschicht (46b) aus dem gleichen Material gebildet werden.

Ausführungsbeispiel 7: Verfahren gemäß einem der vorangehenden Ausführungsbeispiele, bei dem das Halbleitersubstrat (41) eine erste mechanische Gesamtspannung ($\sigma_0$, $\Delta_0$) umfassend eine thermisch induzierte Materialspannung und eine intrinsische Materialspannung, entlang einer lateralen Richtung (43, 43') des Halbleitersubstrates (41) senkrecht zu einer Dickenrichtung aufweist, bei dem eine erste Dielektrikumsschicht (42; 42'), die zwischen dem Substrat (41) und einer zweiten Dielektrikumsschicht (46) angeordnet wird, mit einer zweiten Gesamtspannung ($\sigma_1$, $\Delta_1$) und die zweite Dielektrikumsschicht (46) mit einer dritten mechanischen Gesamtspannung ($\sigma_2$, $\Delta_2$) entlang der lateralen Richtung gebildet werden und wobei die zweite Gesamtspannung ($\sigma_1$, $\Delta_1$) größer als die erste ($\sigma_0$, $\Delta_0$) und der dritte ($\sigma_2$, $\Delta_2$) Gesamtspannung ist oder kleiner als die erste ($\sigma_0$, $\Delta_0$) und die dritte ($\sigma_2$, $\Delta_2$) Gesamtspannung ist.

Ausführungsbeispiel 8: Verfahren gemäß einem der vorangehenden Ausführungsbeispiele, bei der die Dielektrikumsstruktur (42') zumindest drei aneinandergrenzende Dielektrikumsschichten (44; 46; 62) aufweist, wobei zumindest eine Dielektrikumsschicht eine positive mechanische Gesamtspannung ($\sigma_{1-3}$, $\Delta_{1-3}$) und mindestens eine negative mechanische Gesamtspannung ($\sigma_{1-3}$, $\Delta_{1-3}$) bezogen auf das Halbleitersubstrat (41) aufweist.

Ausführungsbeispiel 9: Verfahren gemäß einem der vorangehenden Ausführungsbeispiele, das ferner folgenden Schritt umfasst:

Bilden (130) eines Elektrodenmaterials (48, 54) an einer dem Halbleitersubstrat (41) abgewandten Seite der Dielektrikumsstruktur (42; 42'); und

Bilden (140) eines elektrischen Anschlusses (56a; 56b) mit dem Elektrodenmaterial (48, 54).

Ausführungsbeispiel 10: Verfahren gemäß Ausführungsbeispiel 9, das ferner folgenden Schritt umfasst:
Entfernen (150) eines Materials der Dielektrikumsstruktur von einer Rückseite des Halbleitersubstrats (41), die einer Seite des Halbleitersubstrats, die den Graben (52; 52a; 52b) aufweist, abgewandt ist.

Ausführungsbeispiel 11: Verfahren gemäß Ausführungsbeispiel 10,

bei dem das Halbleitersubstrat (41) als Wafer mit einer Vielzahl von Kondensatorbereichen (70), in denen jeweils zumindest ein Graben (52; 52a; 52b) gebildet ist, bereitgestellt wird; und

bei dem die Dielektrikumsstrukturen (42; 42') über die Vielzahl der Kondensatorbereiche hinweg gebildet ist;

wobei basierend auf den einander entgegengesetzten mechanische Gesamtspannungen ein Materialstress soweit reduziert ist, dass nach dem Entfernen (150) des Materials der Dielektrikumsstruktur von der Rückseite des Halbleitersubstrats (41) eine konvexe oder konkave Verformung (88) des Wafers auf eine Auslenkung mit einer vorbestimmten Obergrenze reduziert ist.

Ausführungsbeispiel 12: Verfahren gemäß Ausführungsbeispiel 11, bei dem der Wafer umfassend eine Fläche mit einem Durchmesser von 150 mm bereitgestellt wird, und bei dem nach dem Entfernen (150) des Materials der Dielektrikumsstruktur von der Rückseite des Halbleitersubstrats (41) die Auslenkung der konkaven oder konvexen Verformung (88) kleiner oder gleich ist als 350 $\mu$m.

Ausführungsbeispiel 13: Kondensator (40; 50; 60; 70) mit folgenden Merkmalen:

einer Dielektrikumsstruktur (42; 42') in einem Graben (52; 52a; 52b) eines Halbleitersubstrats;

wobei die Dielektrikumsstruktur (42; 42') eine Mehrzahl von aneinandergrenzenden Dielektrikumsschichten (44; 46; 62) aufweist, die einander entgegengesetzte mechanische Gesamtspannungen aufweisen.

Ausführungsbeispiel 14: Kondensator gemäß Ausführungsbeispiel 13, der an einer dem Hauptoberflächenbereich abgewandten Rückseite des Halbleitersubstrats (41) einen weiteren Graben (52b) aufweist und wobei an der Rückseite die erste Dielektrikumsschicht (44) und die zweite Dielektrikumsschicht (46) angeordnet sind.

Ausführungsbeispiel 15: Kondensator gemäß Ausführungsbeispiel 13 oder 14, der eine Dauerbetriebsspannung von zumindest 400 V aufweist.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

**Patentansprüche**

1. Verfahren (100) zum Herstellen eines Kondensators (40; 50; 60; 70) mit folgenden Schritten:

    Erzeugen (110) einer Dielektrikumsstruktur (42; 42') in einem Graben (52; 52a; 52b;) eines Halbleitersubstrats (41);
    wobei die Dielektrikumsstruktur (42; 42') eine Mehrzahl von aneinandergrenzenden Dielektrikumsschichten (44; 46; 62) aufweist, die einander entgegengesetzte mechanische Gesamtspannungen aufweisen.
    wobei eine erste Dielektrikumsschicht (44; 46; 62) der Dielektrikumsstruktur (42; 42') Siliziumoxid aufweist und eine Schichtdicke aufweist, die größer ist, als 250 nm und bei der eine zweite Dielektrikumsschicht (44; 46; 62) Siliziumnitrid aufweist und eine Schichtdicke aufweist, die größer ist, als 550nm.

2. Verfahren gemäß Anspruch 1, bei dem die erste Dielektrikumsschicht (44; 46; 62) mit einer Schichtdicke von mehr als 300 nm und die zweite Dielektrikumsschicht (44; 46; 62) mit einer Schichtdicke von zumindest 600 nm erzeugt wird; oder
bei dem die erste Dielektrikumsschicht (44; 46; 62) mit einer Schichtdicke von mehr als 330 nm und die zweite Dielektrikumsschicht mit einer Schichtdicke von zumindest 1000 nm erzeugt wird.

3. Verfahren gemäß Anspruch 1 oder 2, bei dem die erste Dielektrikumsschicht (44; 46; 62) und die zweite Dielektrikumsschicht (44; 46; 62) so gebildet werden, dass die erste Schichtdicke zumindest ein 0,4-faches und höchstens ein 1-faches der zweiten Schichtdicke beträgt;

    dass die erste Schichtdicke zumindest ein 0,5-faches und höchstens ein 1-faches der zweiten Schichtdicke beträgt; oder
    dass die erste Schichtdicke zumindest ein 0,6-faches und höchstens ein 0,99-faches der zweiten Schichtdicke beträgt.

4. Verfahren gemäß einem der vorangehenden Ansprüchen, bei dem das Hableitersubstrat Grabenstrukturen aufweist, die so angeordnet sind, dass durch die Dielektrikumsstruktur eine Integrationsdichte von $\geq 0,5$ nF/mm$^2$, $\geq 1,0$ nF/mm$^2$ oder $\geq 1,25$ nF/mm$^2$ erreicht wird.

5. Verfahren gemäß einem der vorangehenden Ansprüche, bei dem die erste Dielektrikumsschicht (44; 46; 62) durch eine feuchte thermische Oxidation hergestellt wird.

6. Verfahren gemäß einem der vorangehenden Ansprüchen, bei dem das Bilden einer Dielektrikumsschicht (44; 46; 62) der Dielektrikumsstruktur durch Bilden einer ersten Teilschicht (46a) der Dielektrikumsschicht (44; 46; 62) in einem ersten Teilschritt (220) und durch Bilden einer zweiten Teilschicht (46b) der Dielektrikumsschicht (44; 46; 62) in einem zweiten (240) Teilschritt erfolgt, wobei der zweite Teilschritt (240) zu dem ersten Teilschritt (220) einen zeitlichen Abstand (230) aufweist; und wobei die erste Teilschicht (46a) und die zweite Teilschicht (46b) an einander angrenzen.

7. Verfahren gemäß Anspruch 6, bei dem der erste Teilschritt (220) bei einer Prozesstemperatur ausgeführt wird und bei dem der zeitliche Abstand (230) durch zumindest eines aus einem Verharren bei der Prozesstemperatur für eine Zeitdauer, einem Abkühlen ausgehend von der Prozesstemperatur und einem nachfolgendem Erwärmen und/oder einem Erwärmen ausgehend von der Prozesstemperatur und einem nachfolgendem Abkühlen beeinflusst ist; wobei während dem Verharren eine geringere Menge von dielektrischem Material oder keine eine Anordnung von dielektrischem Material verglichen mit dem ersten Teilschritt erfolgt.

8. Verfahren gemäß Anspruch 6 oder 7, bei dem die erste Teilschicht (46a) und die zweite Teilschicht (46b) aus dem gleichen Material gebildet werden.

9. Verfahren gemäß einem der vorangehenden Ansprüche, bei der die Dielektrikumsstruktur (42') zumindest drei aneinandergrenzende Dielektrikumsschichten (44; 46; 62) aufweist, wobei zumindest eine Dielektrikumsschicht eine positive mechanische Gesamtspannung ($\sigma_{1-3}, \Delta_{1-3}$) und mindestens eine negative mechanische Gesamtspannung ($\sigma_{1-3}, \Delta_{1-3}$) bezogen auf das Halbleitersubstrat (41) aufweist.

10. Verfahren gemäß einem der vorangehenden Ansprüche, das ferner folgenden Schritt umfasst:

    Bilden (130) eines Elektrodenmaterials (48, 54) an einer dem Halbleitersubstrat (41) abgewandten Seite der Dielektrikumsstruktur (42; 42'); und
    Bilden (140) eines elektrischen Anschlusses (56a; 56b) mit dem Elektrodenmaterial (48, 54).

11. Verfahren gemäß Anspruch 10, das ferner folgenden Schritt umfasst:
Entfernen (150) eines Materials der Dielektrikumsstruktur von einer Rückseite des Halbleitersubstrats (41), die einer Seite des Halbleitersubstrats, die den Graben (52; 52a; 52b) aufweist, abgewandt ist.

12. Verfahren gemäß Anspruch 11,

    bei dem das Halbleitersubstrat (41) als Wafer mit einer Vielzahl von Kondensatorbereichen (70), in denen jeweils zumindest ein Graben (52; 52a; 52b) gebildet ist, bereitgestellt wird; und bei dem die Dielektrikumsstrukturen (42; 42') über die Vielzahl der Kondensatorbereiche hinweg gebildet ist; wobei basierend auf den einander entgegengesetzten mechanische Gesamtspannungen ein Materialstress soweit reduziert ist, dass nach dem Entfernen (150) des Materials der Dielektrikumsstruktur von der Rückseite des Halbleitersubstrats (41) eine konvexe oder konkave Verformung (88) des Wafers auf eine Auslenkung mit einer vorbestimmten Obergrenze reduziert ist.

13. Kondensator (40; 50; 60; 70) mit folgenden Merkmalen:

einer Dielektrikumsstruktur (42; 42') in einem Graben (52; 52a; 52b) eines Halbleitersubstrats; wobei die Dielektrikumsstruktur (42; 42') eine Mehrzahl von aneinandergrenzenden Dielektrikumsschichten (44; 46; 62) aufweist, die einander entgegengesetzte mechanische Gesamtspannungen aufweisen; wobei eine erste Dielektrikumsschicht (44; 46; 62) der Dielektrikumsstruktur (42; 42') Siliziumoxid aufweist und eine Schichtdicke aufweist, die größer ist, als 250 nm und bei der eine zweite Dielektrikumsschicht (44; 46; 62) Siliziumnitrid aufweist und eine Schichtdicke aufweist, die größer ist, als 550nm.

14. Kondensator gemäß Anspruch 13, der an einer dem Hauptoberflächenbereich abgewandten Rückseite des Halbleitersubstrats (41) einen weiteren Graben (52b) aufweist und wobei an der Rückseite die erste Dielektrikumsschicht (44) und die zweite Dielektrikumsschicht (46) angeordnet sind.

15. Kondensator gemäß Anspruch 13 oder 14, der eine Dauerbetriebsspannung von zumindest 400 V aufweist.

100

| Anordnen eines Halbleitersubstrats | 110 |

| Erzeugen einer Dielektrikumstruktur mit einer Mehrzah von aneinandergrenzenden Dielektrikumsschichten, die einander entgegengesetzte Materialspannungen aufweisen, in einem Graben eines Halbleitersubstrats | 120 |

| Bilden eines Elektrodenmaterials an einer dem Halbleitersubstrat abgewandten Seite der Dielektrikumsstruktur | 130 |

| Bilden eines elektrischen Anschlusses mit dem Elektrodenmaterial | 140 (optional) |

| Entfernen eines Materials der Dielektrikumsstruktur von einer Rückseite, die einer Seite des Halbleitersubstrats, die den Graben aufweist, gegenüberliegt | 150 (optional) |

| Mechanisches Trennen einer Vielzahl von Kondensatoren in dem Halbleitersubstrat | 160 (optional) |

FIG 1

200

| Anordnen einer ersten Dielektrikumsschicht | 210 |

↓

| Anordnen einer ersten Teilschicht einer zweiten Dielektrikumsschicht | 220 |

↓

| Warten<br>und/oder<br>Abkühlen und Erwärmenr | 230 |

↓

| Anordnen einer zweiten Teilschicht einer zweiten Dielektrikumsschicht | 240 |

FIG 2

<u>300</u>

| Anordnen einer ersten Dielektrikumsschicht | 310 |
|---|---|

↓

| Anordnen einer zweiten Dielektrikumsschicht | 320 |
|---|---|

↓

| Anordnen einer dritten Dielektrikumsschicht | 330 |
|---|---|

⋮

| Abscheiden einer leitfähigen Halbleiterschicht oder einer Metallschicht | 340 |
|---|---|

## FIG 3

FIG 4

FIG 5

EP 4 354 512 A2

**FIG 6**

EP 4 354 512 A2

FIG 7A

EP 4 354 512 A2

FIG 7B

FIG 8

EP 4 354 512 A2

82: ◇ nach Oxidation  84a: □ nach 1. Nitrid-Abscheidung  88: + nach RS freiätzen

86: O nach Poly-Abscheidung  84b: △ nach 2. Nitrid-Abscheidung  92: × nach Metallisierung + Poly-ätzen

FIG 9

FIG 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7738226 B2
- EP 1535338 A2
- US 20110001217 A1
- US 8487405 B2

**In der Beschreibung aufgeführte Nicht-Patentliteratur**

- **VOM DORP et al.** Dielectric Layers suitable for High Voltage Integrated Trench Capacitors. *Journal of Vacuum Science and Technology B,* 2011, vol. 29, 01AB04
- **VOM DORP, J.** *Monolithisches RC-Element für leistungselektronische Anwendungen*
- **F. KRACH.** Silicon Nitride as a Potential Dielectric for 600 Volt Capacitors. *WoDiM,* 2014